# EUROPEAN PATENT SPECIFICATION

(11) **EP 3 174 089 B1**
(45) Date of publication and mention of the grant of the patent: **28.04.2021**
(21) Application number: 15824999.5
(22) Date of filing: 08.07.2015
(51) Int. Cl.: H01L 21/677, B65G 49/07, C23C 16/44, H01L 21/205, H01L 21/67, C23C 16/46

(54) **SEMICONDUCTOR MANUFACTURING DEVICE, AND METHOD OF MANUFACTURING SEMICONDUCTOR**
HALBLEITERHERSTELLUNGSVORRICHTUNG UND VERFAHREN ZUR HERSTELLUNG EINES HALBLEITERS
DISPOSITIF ET PROCÉDÉ DE FABRICATION DE COMPOSANTS À SEMI-CONDUCTEUR

(30) Priority: 22.07.2014 JP 2014148961
(43) Date of publication of application: 31.05.2017
(73) Proprietor: Sumitomo Chemical Company Limited, Tokyo 104-8260 (JP)
(72) Inventor: FUJIKURA Hajime, Hitachi-shi Ibaraki 319-1418 (JP); KONNO Taichiro, Hitachi-shi Ibaraki 319-1418 (JP); NONAKA Takehiro, Hitachi-shi Ibaraki 319-1418 (JP); NUMATA Takayuki, Hitachi-shi Ibaraki 319-1418 (JP)
(74) Representative: Vossius & Partner Patentanwälte Rechtsanwälte mbB
(86) International application number: PCT/JP2015/069684
(87) International publication number: WO 2016/013401

(56) References cited:
- WO-A1-2010/068703
- JP-A- S5 986 216
- JP-A- H11 293 459
- JP-A- H11 293 459
- JP-A- 2001 135 704
- JP-A- 2002 075 990
- JP-A- 2006 509 905
- JP-A- 2012 129 554
- US-A1- 2013 189 635

## Description

### 1. TECHNICAL FIELD

The present invention relates to a semiconductor manufacturing apparatus and a semiconductor manufacturing method for heating a substrate to perform a predetermined treatment on the substrate.

### 2. RELATED ART

A conventional semiconductor manufacturing apparatus includes a treatment container, a substrate placing unit that is provided in the treatment container and designed to have a substrate placed thereon, a heating unit designed to heat the substrate within the reaction container, and a gas feeding unit designed to feed a treatment gas into the treatment container. The substrate placing unit is provided with a rotational shaft used to rotate the substrate placing unit. The substrate placed within the treatment container is rotated by rotating the substrate placing unit. The rotational shaft penetrates through a through hole provided in the treatment container (see, for example, JP 2014-103364 A).Between the rotational shaft and the through hole, a seal member such as a magnetic seal and a bellows is provided to keep the treatment container airtight, into which a treatment gas is fed.

When a treatment is performed to deposit a thin film such as a GaN film on the substrate within the treatment container, however, the heating unit heats the treatment container internally to a high temperature and a corrosive gas such as ammonia (NH₃) gas may be fed into the treatment container. If the corrosive gas adheres to the above-mentioned seal member such as a magnetic seal and a bellows, the seal member may be eroded. Therefore, some of the treatments that may be performed on the substrate within the treatment container may not allow the seal member such as a magnetic seal and a bellows to be provided therein. Accordingly, through the gap between the rotational shaft and the through hole, the air containing impurities may enter into the treatment container. As a result, the impurities may be absorbed into the film while the film is being deposited on the substrate. Stated differently, the quality of the film deposited on the substrate may be compromised.

JP H11 293459 A discloses a semiconductor manufacturing apparatus according to the preamble of claim 1.

The objective of the present invention is to provide a technique to achieve the improved quality for the thin film deposited on the substrate.

### SUMMARY

One aspect of the present invention provides a semiconductor manufacturing apparatus including a first container provided with an entrance and an exit for a plurality of substrates, a substrate loading chamber connected to the entrance, wherein the substrate loading chamber is configured to be capable of loading thereinto from outside the substrates that are to be loaded into the first container and of being blocked from the first container and the atmosphere, a substrate unloading chamber connected to the exit, where the substrate unloading chamber is configured to be capable of unloading to outside the substrates that have been unloaded out of the first container and of being blocked from the first container and the atmosphere, a second container disposed within the first container, where the second container is configured to allow a predetermined treatment to be performed therein by heating the substrates, a heating unit configured to heat the substrates housed within the second container, and a substrate transporting mechanism configured to transport the substrates arranged in a line along a transport path extending within the first container from the entrance to the exit and to load and unload the substrates into and out of the second container in order. Here, driving units configured to drive the substrate transporting mechanism are configured to be detachable from the substrate transporting mechanism and respectively disposed within the substrate loading chamber and the substrate unloading chamber.

The present invention enables a film having improved quality to be deposited on a substrate.

### BRIEF DESCRIPTION OF THE DRAWINGS

Fig. 1 is a schematic vertical cross-sectional view showing a semiconductor manufacturing apparatus relating to one embodiment.

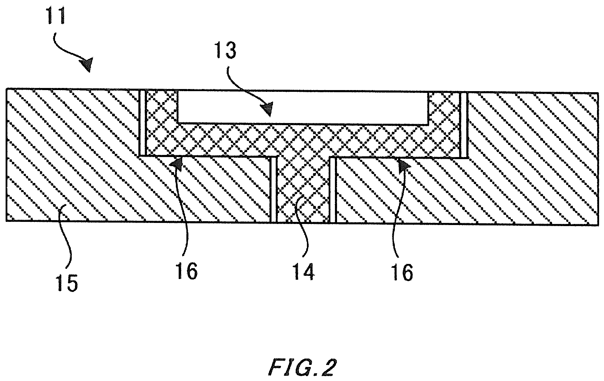

Fig. 2 is a schematic cross-sectional view showing a substrate placing member to be transported within the semiconductor manufacturing apparatus relating to the one embodiment.
Fig. 3A is a schematic view showing a substrate transporting mechanism including a push-pull mechanism of the semiconductor manufacturing apparatus relating to the one embodiment and shows, in particular, how a predetermined treatment is performed on a substrate within a second container.
Fig. 3B is a schematic view showing how a substrate is transported by the substrate transporting mechanism.
Fig. 3C is a schematic view showing how a substrate is transported by a substrate transporting mechanism.
Fig. 4A is a schematic view showing a substrate transporting mechanism including a walking beam mechanism of the semiconductor manufacturing apparatus relating to the one embodiment, and shows, in particular, how a predetermined treatment is performed on a substrate within a second container.
Fig. 4B is a schematic view showing how a substrate is transported by the substrate transporting mechanism.
Fig. 4C is a schematic view showing how a substrate is transported by the substrate transporting mechanism.
Fig. 4D is a schematic view showing how a substrate is transported by the substrate transporting mechanism.
Fig. 4E is a schematic view showing how a substrate is transported by the substrate transporting mechanism.
Fig. 5A is a schematic view showing a substrate transporting mechanism including a feeding screw mechanism of the semiconductor manufacturing apparatus relating to the one embodiment and shows, in particular, how a predetermined treatment is performed on a substrate within a second container.
Fig. 5B is a schematic view showing how a substrate is transported by the substrate transporting mechanism.
Fig. 5C is a schematic view showing how a substrate is transported by the substrate transporting mechanism.
Fig. 5D is a schematic view showing how a substrate is transported by the substrate transporting mechanism.
Fig. 5E is a schematic view showing how a substrate is transported by the substrate transporting mechanism.
Fig. 6 is a flow chart showing a semiconductor manufacturing process relating to one embodiment.
Fig. 7 is a flow chart showing how the semiconductor manufacturing apparatus operates to perform the semiconductor manufacturing process relating to the one embodiment. Fig. 8 shows an operational sequence of a heating unit included in the semiconductor manufacturing apparatus relating to the one embodiment.
Fig. 9A is a schematic vertical cross-sectional view showing a semiconductor manufacturing apparatus relating to another embodiment and shows, in particular how an upper container included in a second container is lifted.
Fig. 9B shows how the upper container included in the second container is lifted.
Fig. 9C shows how the upper container included in the second container is lifted.
Fig. 10A is a schematic vertical cross-sectional view showing a semiconductor manufacturing apparatus relating to another embodiment.
Fig. 10B is a schematic vertical cross-sectional view showing the semiconductor manufacturing apparatus relating to the other embodiment.
Fig. 10C is a schematic vertical cross-sectional view showing the semiconductor manufacturing apparatus relating to the other embodiment.
Fig. 11 is a schematic horizontal cross-sectional view showing a semiconductor manufacturing apparatus relating to another embodiment.
Fig. 12A is a schematic view showing a conventional semiconductor manufacturing apparatus and, more specifically, a schematic vertical cross-sectional view showing how the semiconductor manufacturing apparatus performs deposition.
Fig. 12B is a schematic top view showing how the semiconductor manufacturing apparatus performs deposition.
Fig. 12C is a schematic vertical cross-sectional view showing how the semiconductor manufacturing apparatus transports a substrate.
Fig. 12D is a schematic top view showing how the semiconductor manufacturing apparatus transports a substrate.
Fig. 13 shows an operational sequence of the heating unit included in the conventional semiconductor manufacturing apparatus.

### EXEMPLARY EMBODIMENTS OF THE INVENTION

The following describes one embodiment with reference to the drawings.

### (1) Structure of Semiconductor Manufacturing Apparatus

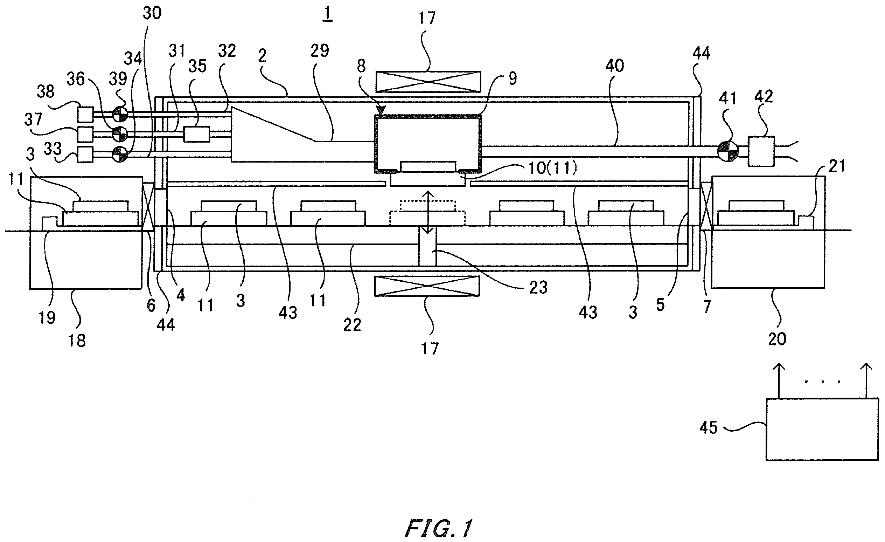

The structure of a semiconductor manufacturing apparatus relating to one embodiment is described mainly with reference to Fig. 1. Fig. 1 is a schematic vertical cross-sectional view showing a semiconductor manufacturing apparatus 1 relating to the present embodiment. The following description is made taking, as an exemplary predetermined treatment performed by heating a substrate, deposition to form a gallium nitride (GaN) film on the substrate.

As shown in Fig. 1, the semiconductor manufacturing apparatus 1 includes a first container 2, which is a cylindrical airtight container. The first container 2 is made of a heat resistant material such as quartz (SiO₂) or silicon carbide (SiC), for example. The first container 2 has an entrance 4 and an exit 5 for a substrate (wafer) 3. The entrance 4 and the exit 5 are respectively provided in the side walls of the first container 2, for example.

The entrance 4 and the exit 5 are respectively provided with gate valves 6 and 7, which serve as sluice valves. To the gate valves 6 and 7, a control unit 45, which will be described later, is electrically connected. The control unit 45 is configured to open and close the gate valves 6 and 7 at predetermined timings by controlling the power fed to the gate valves 6 and 7. For example, the control unit 45 may be configured to open the gate valves 6 and 7 concurrently and close the gate valves 6 and 7 concurrently by controlling the power fed to the gate valves 6 and 7.

To the entrance 4, a substrate loading chamber 18 is connected. In other words, the substrate loading chamber 18 is provided outside the first container 2 with the entrance 4 placed therebetween. The substrate loading chamber 18 is configured to be capable of being blocked from the first container 2 via the gate valve 6. Stated differently, the substrate loading chamber 18 is configured to be capable of communicating with the first container 2 through the entrance 4 when the gate valve 6 is opened. In addition, the substrate loading chamber 18 is configured to be capable of loading a substrate 3 therein from outside the substrate loading chamber 18 (i.e., outside the semiconductor manufacturing apparatus 1). The substrate loading chamber 18 is configured to be capable of blocking the air. The substrate loading chamber 18 is configured to be capable of being depressurized to the pressure at substantially the same level as the pressure in the first container 2 (for example, a pressure lower than the atmospheric pressure, for example, the vacuum).

Within the substrate loading chamber 18, a substrate loading mechanism 19 is provided. The substrate loading mechanism 19 is configured to be capable of transporting a substrate 3 (for example, a substrate 3 placed on a substrate placing member 11, which will be described later) between the substrate loading chamber 18 and the first container 2. In addition, the substrate loading mechanism 19 also serves as a driving unit to drive a substrate transporting mechanism 22, which will be described later. The substrate loading mechanism 19 is configured to be detachable from the substrate transporting mechanism 22, which is provided within the first container 2 and will be described later. In other words, the substrate loading mechanism 19 is configured to be only connected to the substrate transporting mechanism 22, which will be described later, when the gate valve 6 is opened. The substrate loading mechanism 19 is housed within the substrate loading chamber 18 when the gate valve 6 is closed. The substrate loading mechanism 19 may be configured to be capable of transporting a substrate 3 between the outside of the substrate loading chamber 18 and the substrate loading chamber 18. To the substrate loading mechanism 19, the control unit 45, which will be described later, is electrically connected. The control unit 45 is configured to allow the substrate loading mechanism 19 to load a substrate 3 into the first container 2 and to drive the substrate transporting mechanism 22 at predetermined timings by controlling the power fed to the substrate loading mechanism 19.

The exit 5 is connected to a substrate unloading chamber 20. In other words, the substrate unloading chamber 20 is provided outside the first container 2 with the exit 5 placed therebetween. The substrate unloading chamber 20 is configured to be capable of being blocked from the first container 2 via the gate valve 7. The substrate unloading chamber 20 is configured to be capable of communicating with the first container 2 through the exit 5 when the gate valve 7 is opened. In addition, the substrate unloading chamber 20 is configured to be capable of unloading a substrate 3 that has been unloaded from the first container 2 to outside the substrate unloading chamber 20 (i.e., outside the semiconductor manufacturing apparatus 1). The substrate unloading chamber 20 is configured to be capable of blocking the air. The substrate unloading chamber 20 is configured to be capable of being depressurized to the pressure at substantially the same level as the pressure in the first container 2 (for example, a pressure lower than the atmospheric pressure, for example, the vacuum).

Within the substrate unloading chamber 20, a substrate unloading mechanism 21 is provided. The substrate unloading mechanism 21 is configured to be capable of transporting a substrate 3 (for example, a substrate 3 placed on the substrate placing member 11, which will be described later) between the first container 2 and the substrate unloading chamber 20. In addition, the substrate unloading mechanism 21 also serves as a driving unit to drive the substrate transporting mechanism 22, which will be described later. The substrate unloading mechanism 21 is configured to be detachable from the substrate transporting mechanism 22, which is provided within the first container 2 and will be described later. In other words, the substrate unloading mechanism 21 is configured to be only connected to the substrate transporting mechanism 22, which will be described later, when the gate valve 7 is opened. The substrate unloading mechanism 21 is housed within the substrate unloading chamber 20 when the gate valve 7 is closed. The substrate unloading mechanism 21 may be configured to be capable of transporting a substrate 3 between the substrate unloading chamber 20 and the outside of the substrate unloading chamber 20. To the substrate unloading mechanism 21, the control unit 45, which will be described later, is electrically connected. The control unit 45 is configured to allow the substrate unloading mechanism 21 to unload a substrate 3 from the first container 2 and to drive the substrate transporting mechanism 22 at predetermined timings by controlling the power fed to the substrate unloading mechanism 21.

Within the first container 2, a second container 8 is provided to perform a predetermined treatment by heating a substrate 3. For example, in the second container 8, a substrate 3 housed within the second container 8 is heated by a heater 17, which will be described later, to perform deposition that forms a GaN film on the substrate 3. The second container 8 includes an upper container 9 having an opening in the lower end thereof and a lower container 10 configured to be capable of closing the opening in the upper container 9. The upper container 9 and the lower container 10 are each made of, for example, quartz, carbon, silicon carbide (SiC).

The lower container 10 can serve, for example, as the substrate placing member 11 configured to have a substrate 3 placed thereon. A substrate 3 may be transported along a transport path, which will be described later and provided at least within the first container 2, while being placed on the substrate placing member 11. As shown in Fig, 2, for example, a circular depressed portion 13 is provided in the substrate placing member 11 at the position at which the substrate 3 can be placed. The depressed portion 13 may be formed to have a diameter slightly larger than the diameter of the substrate 3. By placing the substrate 3 within the depressed portion 13, the substrate 3 can be easily accurately positioned and, at the same time, can be prevented from being misaligned due to the transport of the substrate placing member 11. Here, it should be noted that the substrate placing member 11 may be configured to allow not only a single substrate 3 to be placed thereon but also a plurality of substrates 3 to be placed thereon. If such is the case, the substrate placing member 11 may be configured in such a manner that a plurality of substrates 3 can be placed adjacently to each other on the same plane and along the same circumference. Here, the expression "on the same plane" is not limited to mean "on exactly the same plane." It is acceptable if a plurality of substrates 3 are placed without overlapping each other when the substrate placing member 11 is seen from above.

As shown in Fig. 1, a heater 17 is provided outside the first container 2, as a heating unit to heat a substrate 3 housed within the second container 8 to a predetermined temperature (for example, 800°C to 900°C). The heater 17 is, for example, cylindrically shaped. The heater 17 surrounds the wall of the first container 2. More specifically, the heater 17 is provided outside the first container 2 to externally surround the second container 8. To the heater 17, the control unit 45, which will be described later, is electrically connected. The control unit 45 is configured to control the power fed to the heater 17 in such a manner that the temperature of a substrate 3 housed within the second container 8 reaches a predetermined temperature.

Within the first container 2, a transport path for a substrate 3 is provided that extends from the entrance 4 to the exit 5. The transport path is configured to allow a plurality of (for example, five) substrates 3 to be arranged in a single line. The transport path is, for example, shaped like a straight line. The transport path may be defined in such a manner that, for example, the transport direction of substrates 3 within the first container 2 is parallel to (the same as) the source gas flow direction within the second container 8.

The transport path between the second container 8 and the exit 5 may be configured in such a manner that the temperature of a treated substrate 3, on which a predetermined treatment has been performed within the second container 8 and unloaded out of the second container 8 can be lowered to a predetermined temperature (for example, the temperature at which the treated substrate 3 can be unloaded out of the first container 2) during the transport path. In other words, the transport path between the second container 8 and the exit 5 may be configured such that the temperature of a treated substrate 3 that has been unloaded out of the second container 8 may be lowered to a predetermined temperature by heat dissipation during the transport path while the treated substrate 3 is transported along the transport path from the second container 8 to the exit 5.

The length of the transport path between the second container 8 and the exit 5 is determined by the transport speed of a substrate 3, the temperature lowering rate of a substrate 3 and a desired temperature lowering amount of a substrate 3. Here, the transport speed indicates the speed at which a substrate 3 is transported along the transport path between the second container 8 and the exit 5. The transport speed is mainly determined by the duration of a predetermined treatment performed within the second container 8. The temperature lowering rate indicates the rate at which the temperature of a substrate 3 is lowered during the transport path between the second container 8 and the exit 5. The temperature lowering rate is mainly determined by the position at which the heater 17 is located, the heating temperature applied by the heater 17, the heat transfer rate of the first container 2 and the like. The predetermined amount of temperature lowering is defined as the difference between the temperature of a treated substrate 3 immediately after the substrate 3 is unloaded out of the second container 8 and at least the predetermined temperature of the substrate 3 at which the substrate 3 can be unloaded out of the first container 2.

The transport path between the second container 8 within the first container 2 and the exit 5 may be under a protective gas atmosphere in which a protective gas to protect the surface of a treated substrate 3 is enclosed. The protective gas can be, for example, a hydrogen containing gas such as ammonia (NH₃) gas and the like.

The transport path between the entrance 4 and the second container 8 may be configured to have such a length that the temperature of an untreated substrate 3 to be housed within the second container 8 can be raised to a predetermined temperature. Stated differently, the transport path between the entrance 4 and the second container 8 may be configured to have such a length that preheating can be performed on the untreated substrate 3. To be more specific, the transport path between the entrance 4 and the second container 8 may be configured to have such a length that the temperature of an untreated substrate 3 can be raised close to the temperature (the treatment temperature) that allows a predetermined treatment to be started on the untreated substrate 3 in the second container 8 immediately after the untreated substrate 3 is housed within the second container 8. For example, the transport path between the entrance 4 and the second container 8 may be configured to have such a length that the temperature of an untreated substrate 3 to be loaded into the second container 8 can be raised to the temperature within +- 200°C of the treatment temperature, preferably to the temperature within +- 100°C of the treatment temperature, more preferably to the temperature within +- 50°C of the treatment temperature.

The transport path within the first container 2 between the entrance 4 and the second container 8 may be under a protective gas atmosphere in which a protective gas to protect the surface of an untreated substrate 3 is enclosed. The protective gas can be, for example, a hydrogen containing gas such as ammonia (NH₃) gas and the like.

Within the first container 2, the substrate transporting mechanism 22 is provided that is configured to transport a plurality of substrates 3 arranged in a line along the transport path defined within the first container 2 and to load and unload the substrates 3 in order into and out of the second container 8.

The substrate transporting mechanism 22 is configured to transport a substrate 3 when the gate valves 6 and 7 are opened to allow the substrate transporting mechanism 22 to be connected to the substrate loading mechanism 19 and to the substrate unloading mechanism 21. In other words, the substrate transporting mechanism 22 is configured to be capable of transporting a substrate 3 along the transport path within the first container 2 only when the gate valves 6 and 7 are opened. For example, the substrate transporting mechanism 22 is configured to load a substrate 3 into the first container 2 by receiving the substrate 3 from the substrate loading mechanism 19 and, at the same time, to unload a substrate 3 out of the first container 2 by passing the substrate 3 to the substrate unloading mechanism 21.

The substrate transporting mechanism 22 may include one of, for example, a push-pull mechanism, a walking beam mechanism or a feeding screw mechanism. In other instances, the substrate transporting mechanism 22 may include, for example, a pull-push mechanism or conveyor belt.

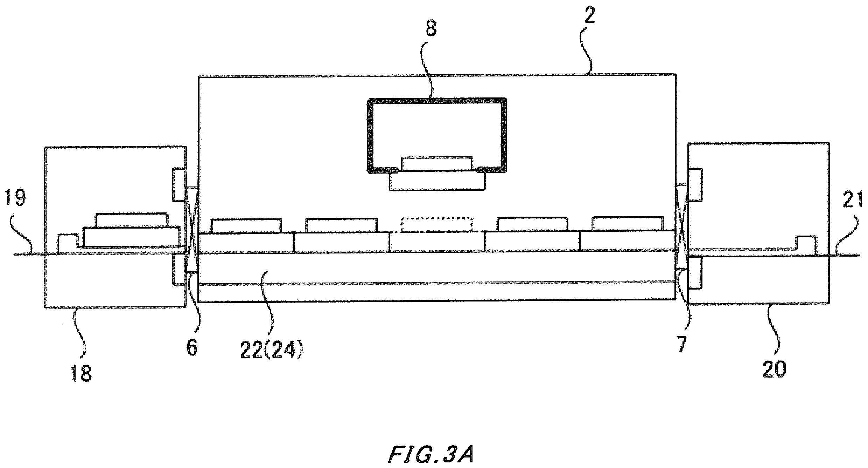

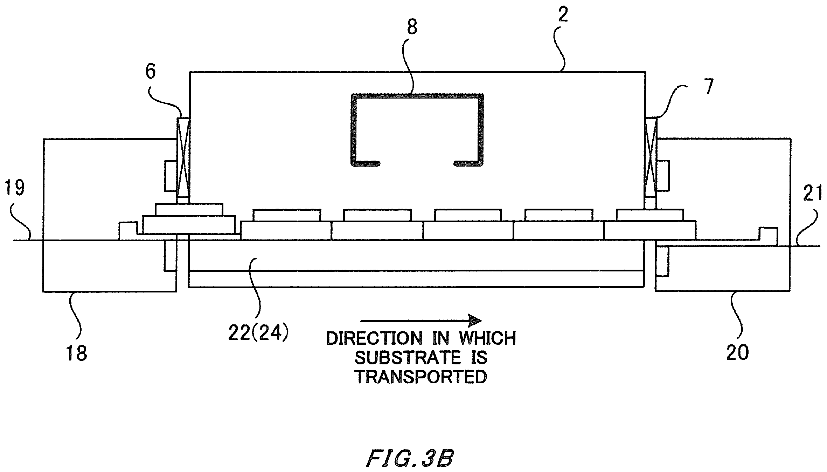

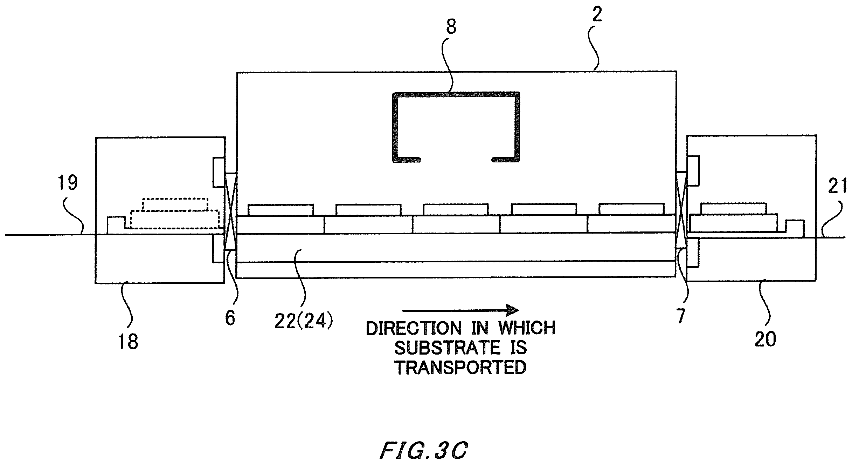

Figs. 3A to 3C schematically show a substrate transporting mechanism 22 including a push-pull mechanism. As shown in Figs. 3A to 3C, when including a push-pull mechanism, the substrate transporting mechanism 22 may include a substrate transport stage 24 formed along the transport path for a substrate 3 within the first container 2. The substrate transport stage 24 may be made of, for example, quartz and the like. When the substrate transporting mechanism 22 is configured in this manner, the substrate loading mechanism 19 loads a substrate 3 (the substrate placing member 11 on which the substrate 3 is placed) in a sliding manner onto the substrate transport stage 24 and places the substrate 3 on the substrate transport stage 24 when the gate valves 6 and 7 are opened to allow the substrate loading chamber 18 and the substrate unloading chamber 20 to communicate with the first container 2, as shown in Figs. 3A to 3C. At the same time, substrates 3, which have been placed on the substrate transport stage 24, are pushed forward (downstream) and thus transported along the transport path. A substrate 3 at the most downstream position is unloaded by the substrate unloading mechanism 21 from the first container 2 to the substrate unloading chamber 20.

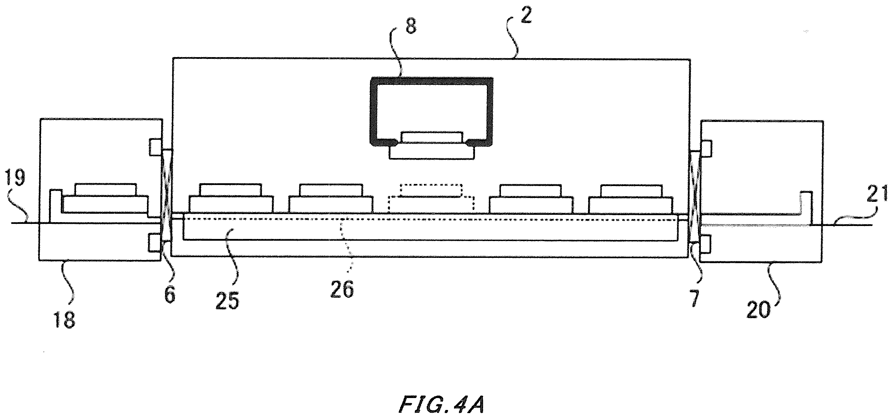

Figs. 4A to 4E schematically show a substrate transporting mechanism 22 including a walking beam mechanism. As shown in Fig. 4A, when including a walking beam mechanism, the substrate transporting mechanism 22 may include a stationary beam (or fixed skid) 25 and a walking beam (or mobile skid) 26. The stationary beam 25 and the walking beam 26 are respectively provided along the transport path for substrates 3 within the first container 2. The walking beam 26 is configured to be capable of moving up and down and back and forth. In other words, the walking beam 26 is configured to rectangularly or circularly move. The walking beam 26 may be housed lower than the upper end surface of the stationary beam 25. The stationary beam 25 and the walking beam 26 may be made of, for example, quartz and the like.

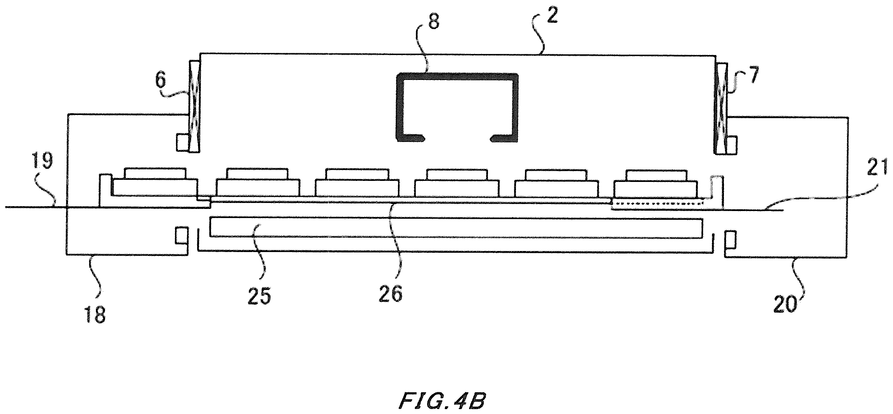

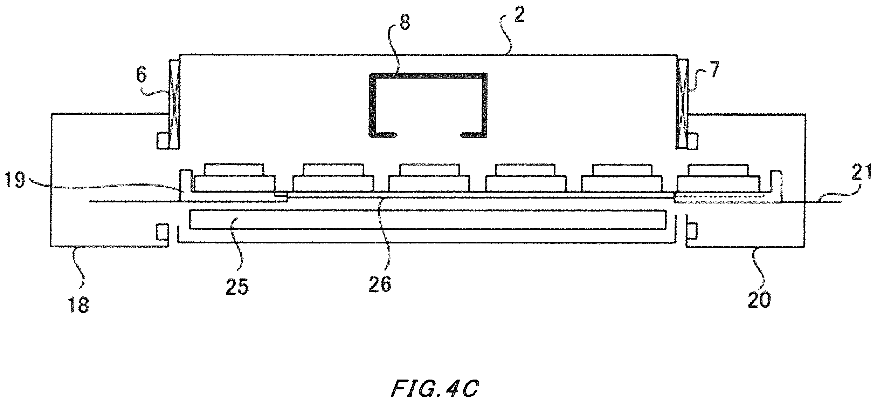

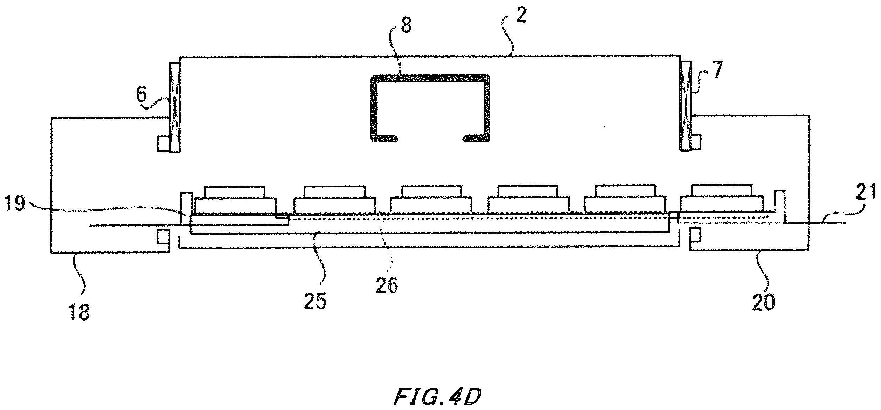

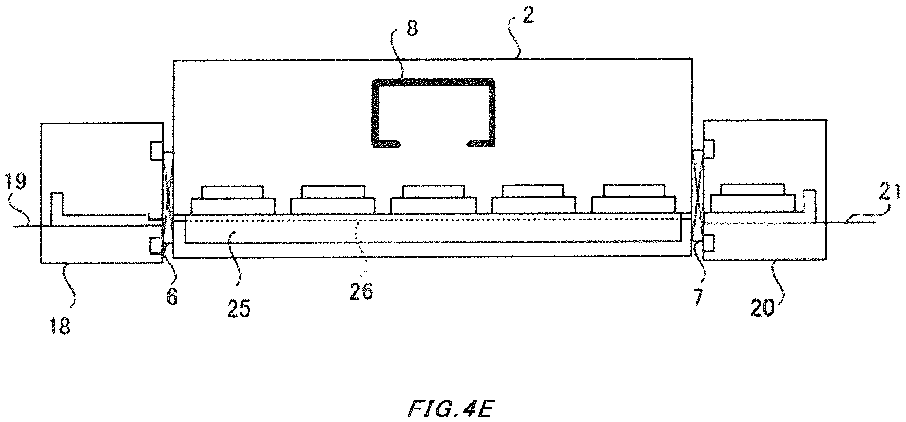

As shown in Figs. 4A to 4E, when the substrate transporting mechanism 22 is configured in the above-described manner, substrates 3 are transported, for example, by repetitions of a series of upward, forward, downward and backward movements of the walking beam 26. To be specific, first of all, a predetermined treatment is performed on a substrate 3 within the second container 8 as shown in Fig. 4A. Once the predetermined treatment is completed, the substrate 3 is unloaded out of the second container 8. As shown in Fig. 4B, the gate valves 6 and 7 are then opened to allow the substrate loading chamber 18 and the substrate unloading chamber 20 to communicate with the first container 2. Subsequently, the substrate loading mechanism 19 and the substrate unloading mechanism 21 are respectively connected to the walking beam 26 included in the substrate transporting mechanism 22. After this, the walking beam 26 moves upward. Subsequently, as shown in Figs. 4C and 4D, the walking beam 26 moves forward and then downward, so that the substrate 3 (or the substrate placing member 11 on which the substrate 3 is placed) is placed on the stationary beam 25. Following this, as shown in Fig. 4E, the substrate loading mechanism 19 retreats into the substrate loading chamber 18 and, at the same time, the walking beam 26 moves backward.

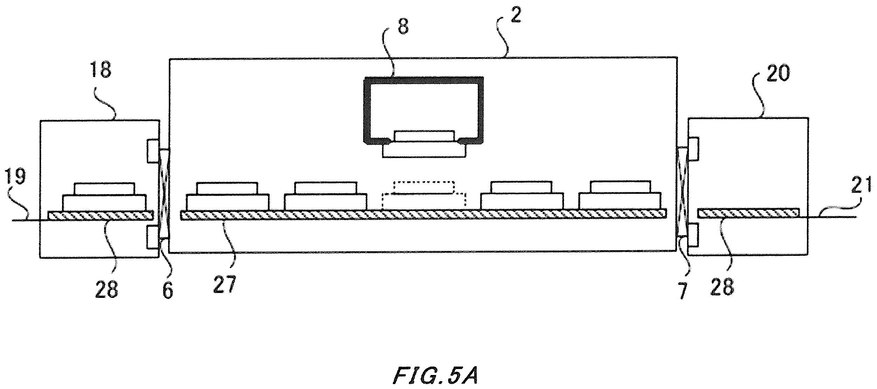

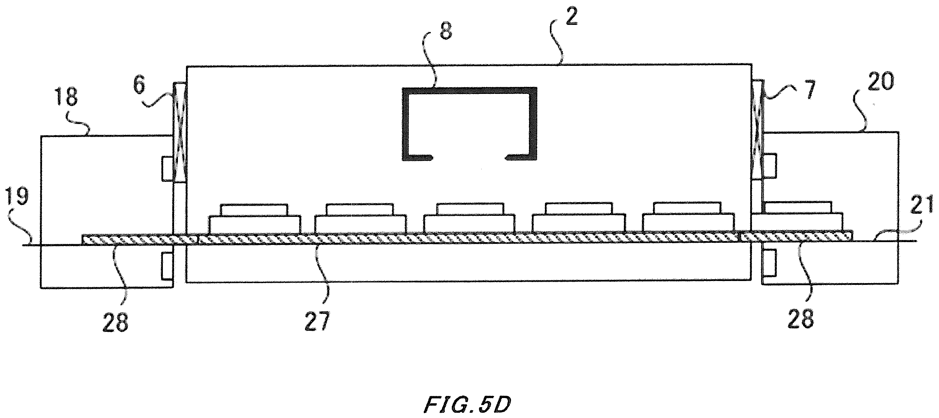

Figs. 5A to 5E schematically show a substrate transporting mechanism 22 including a feeding screw mechanism. As shown in Fig. 5A, when including a feeding screw mechanism, the substrate transporting mechanism 22 includes a feeding screw (for example, a ball screw) 27 and a nut (not shown). The feeding screw 27 and the nut are screwed to each other.

In this case, at least one of the substrate loading mechanism 19 and the substrate unloading mechanism 21 may include an auxiliary feeding screw 28. The auxiliary feeding screw 28 is configured to be connectable to the feeding screw 27 at one end thereof. The auxiliary feeding screw 28 is configured to be connected to the feeding screw 27 disposed in the first container 2 when the substrate loading chamber 18 and the substrate unloading chamber 20 establish communication with the first container 2. The feeding screw 27 is configured to be rotated by the rotation of the auxiliary feeding screw 28 connected thereto.

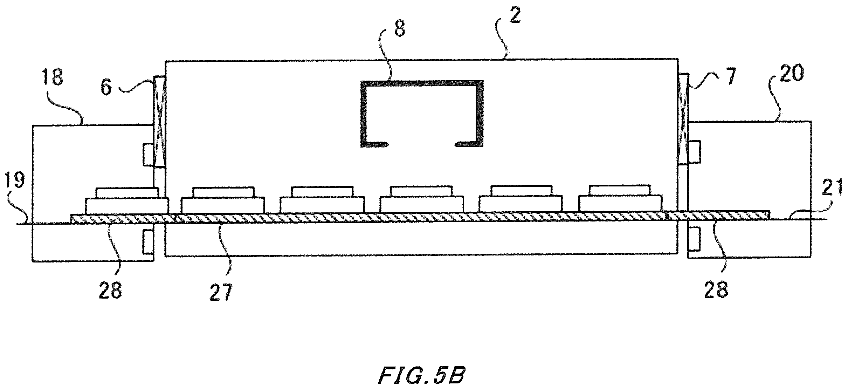

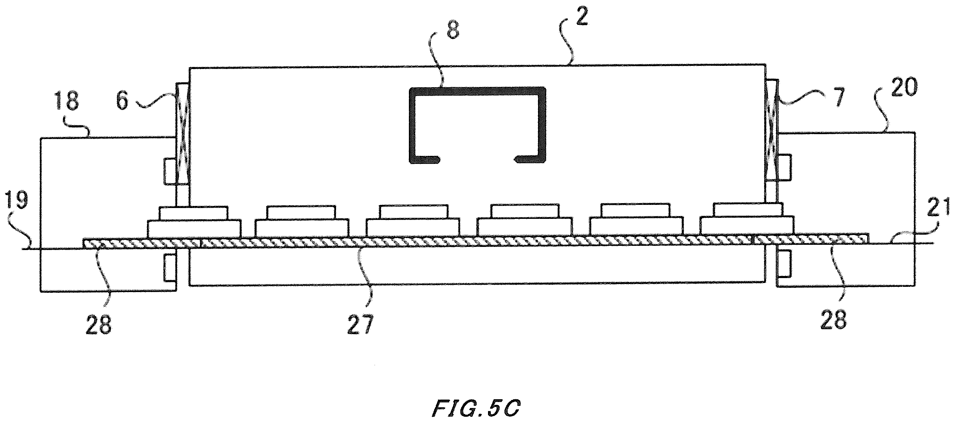

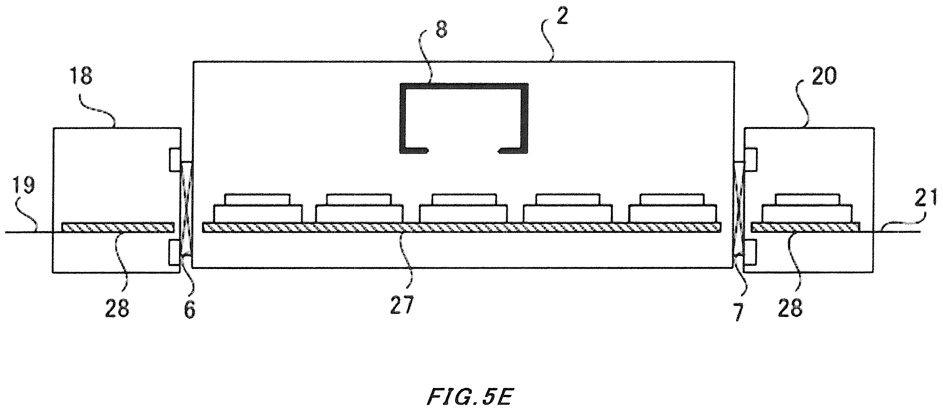

As shown in Figs. 5A to 5E, when the substrate transporting mechanism 22 is configured in the above-described manner, substrates 3 are transported as a result of the rotation of the feeding screw 27. To be specific, first of all, a predetermined treatment is performed on a substrate 3 within the second container 8 as shown in Fig. 5A. Once the predetermined treatment is completed, the substrate 3 is unloaded out of the second container 8. As shown in Fig. 5B, the gate valves 6 and 7 are then opened to allow the substrate loading chamber 18 and the substrate unloading chamber 20 to communicate with the first container 2. Following this, the auxiliary feeding screw 28 and the feeding screw 27 are connected to each other. Subsequently, as shown in Figs. 5C to 5D, the feeding screw 27 is rotated in a predetermined direction to move the substrates 3 in a linear direction (i.e., the horizontal direction). As a result, the substrates 3 are transported along the transport path. As shown in Fig. 5E, after the substrate transporting mechanism 22 completes the transport of the substrates 3 and the substrate loading mechanism 19 and the substrate unloading mechanism 21 respectively retreat into the substrate loading chamber 18 and the substrate unloading chamber 20, the gate valves 6 and 7 are closed.

As shown in Fig. 1, the substrate transporting mechanism 22 may include a lift mechanism 23 to load and unload substrates 3 in order into and out of the second container 8. The lift mechanism 23 is configured to lift and lower, for example, the substrate placing member 11, which is formed as the lower container 10 constituting the second container 8. The lift mechanism 23 is positioned, for example, at the center of the bottom of the first container 2 to oppose the second container 8 disposed within the first container 2. The lift mechanism 23 supports the substrate placing member 11 from below and lifts the substrate placing member 11. In this manner, the lift mechanism 23 closes the opening in the upper container 9. In addition, the lift mechanism 23 opens the opening in the upper container 9 by lowering the substrate placing member 11. When the substrate placing member 11 includes a liftable unit 14 and a non-liftable unit 15, the lift mechanism 23 is configured to lift and lower only the liftable unit 14 of the substrate placing member 11. With such a configuration, the substrate 3 placed on the substrate placing member 11 can be loaded and unloaded into and out of the second container 8. To the lift mechanism 23, the control unit 45, which will be described later, is electrically connected. The control unit 45 is configured to control the power fed to the lift mechanism 23 in such a manner that the substrate placing member 11 is at a predetermined height at a predetermined timing.

The second container 8 is provided with a source gas feeding nozzle 29 to feed a source gas to a substrate 3 housed within the second container 8. The upstream end of the source gas feeding nozzle 29 is connected to the downstream end of a source gas feeding tube to feed the source gas. To be more specific, the upstream end of the source gas feeding nozzle 29 is connected to the downstream ends of a Group V source gas feeding tube 30, a Group III source gas feeding tube 31 and a cleaning gas feeding tube 32. The Group V source gas feeding tube 30, the Group III source gas feeding tube 31 and the cleaning gas feeding tube 32 respectively penetrate through the side wall of the first container 2. The Group V source gas feeding tube 30, the Group III source gas feeding tube 31 and the cleaning gas feeding tube 32 are made of, for example, quartz and the like.

The Group V source gas feeding tube 30 includes, in order from upstream, a Group V source gas source 33 and a valve 34 that serves as an on-off valve to feed and stop a Group V source gas to the substrate 3 housed within the second container 8. Through the Group V source gas feeding tube 30, the Group V source gas such as ammonia (NH₃) gas is fed to the substrate 3 housed within the second container 8 via the source gas feeding nozzle 29.

The Group V source gas feeding tube 30 may be configured to be capable of feeding a carrier gas such as hydrogen (H₂) gas, nitrogen (N₂) gas or a gas mixture thereof concurrently with feeding the Group V source gas.

The Group III source gas feeding tube 31 is provided with a Ga tank 35 that is configured to store therein a gallium (Ga) melt. The Ga tank 35 may be disposed within the first container 2. The Ga tank 35 may be made of, for example, quartz and the like. On the upstream side with respect to the Ga tank 35, the Group III source gas feeding tube 31 is provided with, in order from upstream, a reactant gas source 37 and a valve 36 that serves as an on-off valve to feed and stop a reactant gas to the Ga tank 35. Through the Group III source gas feeding tube 31, the reactant gas such as hydrogen chloride (HCl) gas is first fed into the Ga tank 35. As a result of feeding the reactant gas into the Ga tank 35, the reactant gas reacts with the Ga melt within the Ga tank 35 to produce gallium chloride (GaCl) gas, which will be used as the Group III source gas. The GaCl gas produced in the Ga tank 35 is fed through the Group III source gas feeding tube 31 and then the source gas feeding nozzle 29 to the substrate 3 within the second container 8.

The Group III source gas feeding tube 31 may be configured to be capable of feeding a carrier gas such as H₂ gas, N₂ gas or a gas mixture thereof concurrently with feeing the Group III source gas.

The cleaning gas feeding tube 32 includes, in order from upstream, a cleaning gas source 38 and a valve 39 that serves as an on-off valve to feed and stop a cleaning gas into the second container 8. Through the cleaning gas feeding tube 32, the cleaning gas that is capable of etching a GaN film, such as a hydrochloric acid (HCl) gas and chlorine (Cl₂) gas, is fed through the source gas feeding nozzle 29 into the second container 8.

A source gas feeding unit relating to the present embodiment is mainly constituted by the source gas feeding nozzle 29, the Group V source gas feeding tube 30, the Group III source gas feeding tube 31 and the cleaning gas feeding tube 32. The valves 34, 36 and 39 respectively provided in the Group V source gas feeding tube 30, the Group III source gas feeding tube 31 and the cleaning gas feeding tube 32, the Group V source gas source 33, the reactant gas source 37, the cleaning gas source 38, the Ga tank 35 and the like may be considered to constitute the source gas feeding unit.

The second container 8 is connected to the upstream end of a gas discharge tube 40 configured to principally discharge the atmosphere within the second container 8. The gas discharge tube 40 penetrates through the side wall of the first container 2. The gas discharge tube 40 is provided with, in order from upstream, an auto pressure controller (APC) valve 41 that serves, for example, as a pressure regulating device and a vacuum pump 42 that serves, for example, as an evacuating device. As a result of evacuating the second container 8 to form a vacuum using the vacuum pump 42, the pressure within the first and second containers 2 and 8 can be regulated to reach a predetermined pressure (for example, a pressure lower than the atmospheric pressure, such as the vacuum state). A gas discharge unit relating to the present embodiment is principally constituted by the gas discharge tube 40. The APC valve 41, the vacuum pump 42 and the like may be considered to constitute the gas discharge unit.

Within the first container 2, a barrier plate 43 may be provided to, for example, prevent the reactant gas such as the Group III source gas from flowing into the transport path. The barrier plate 43 may be disposed in the space between the transport path within the first container 2 and the source gas feeding nozzle 29.

A cooling unit 44 may be provided on the side wall of the first container 2 to cool, for example, the side wall of the first container 2. The cooling unit 44 may include, for example, a coolant channel through which a coolant such as water and air flows. Accordingly, even if the heater 17 maintains the heating temperature at a predetermined temperature, the cooling unit 44 can prevent the constituents of the semiconductor manufacturing apparatus 1 from being damaged by the heat provided by the heater 17. Specifically speaking, the cooling unit 44can prevent the constituents in the vicinity of the entrance 4 and the exit 5 from being damaged by the heat. For example, the cooling unit 44 can prevent the substrate loading mechanism 19 within the substrate loading chamber 18, the substrate unloading mechanism 21 within the substrate unloading chamber 20, the gate valves 6 and 7 and the like from being damaged by the heat.

To the gate valves 6 and 7, the heater 17, the substrate loading mechanism 19, the substrate unloading mechanism 21, the substrate transporting mechanism 22, the valves 34, 36 and 39, the APC valve 41, the vacuum pump 42 and the like, the control unit 45 is connected. The control unit 45 controls the opening and closing of the gate valves 6 and 7, the regulation of the temperature of the heater 17, the loading of substrates by the substrate loading mechanism 19, the unloading of substrates by the substrate unloading mechanism 21, the transport of substrates by the substrate transporting mechanism 22, the opening and closing of the valves 34, 36 and 39, the regulation of the aperture of the APC valve 41, the activation and deactivation of the vacuum pump 42 and the like.

### (2) Semiconductor Manufacturing Method

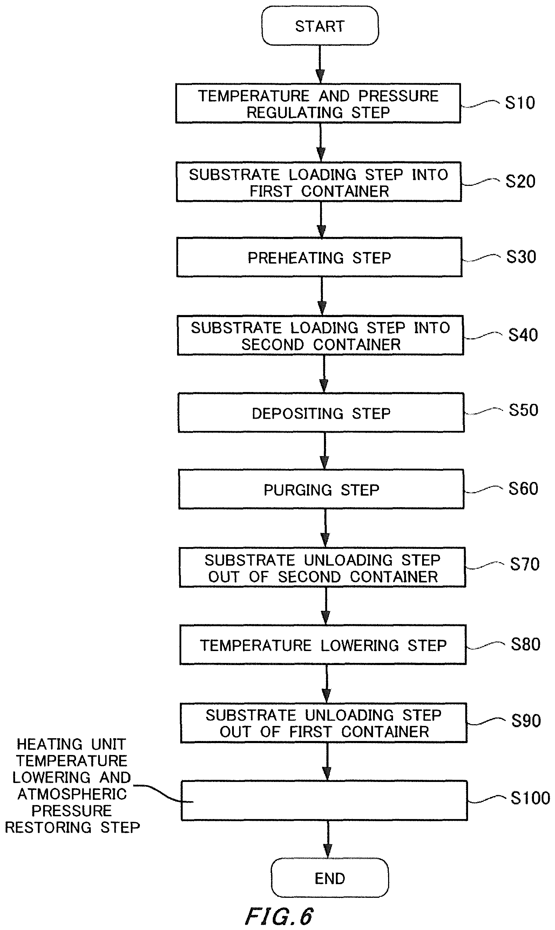

The following describes one of the steps of a semiconductor manufacturing process relating to the present embodiment, which is a substrate treating step performed by the above-described semiconductor manufacturing apparatus 1, principally with reference to Fig. 6. Fig. 6 is a flow chart showing a substrate treating step to be performed on a single substrate 3, in accordance with the present embodiment. The following describes an exemplary case where a gallium nitride (GaN) film is formed on the substrate 3 within the second container 8, for example. The following description is made on the assumption that the actions and operations of the respective units of the semiconductor manufacturing apparatus 1 are controlled by the control unit 45.

### (Temperature and Pressure Regulating Step (S10))

As shown in Fig. 6, to start with, power is fed to the heater 17, which serves as a heating unit, to heat the surface of the substrate 3 to a predetermined temperature (for example, 800°C to 1100C°). Here, the heating temperature of the heater 17 is regulated by the control unit 45 by controlling the power fed to the heater 17. The power continues to be fed to the heater 17 until a heating unit temperature lowering and atmospheric pressure restoring step (S100), which will be described later, starts.

Additionally, in order to achieve a predetermined pressure (for example, the pressure lower than the atmospheric pressure such as the vacuum state) within the first container 2, the aperture of the APC valve 41 is controlled and the vacuum pump 42 evacuates, through the second container 8, the first container 2 to form a vacuum. To be specific, while the opening formed at the lower end of the upper container 9 constituting the second container 8 is kept opened, the vacuum pump 42 evacuates the second container 8 to form a vacuum. In this way, the first container 2 is evacuated to form a vacuum through the opening formed at the lower end of the upper container 9.

### (Substrate Loading Step into First Container (S20))

Once the predetermined pressure is achieved in the first container 2 and the heating temperature of the heater 17 reaches the predetermined temperature, the gate valve 6 between the substrate loading chamber 18, where the pressure is regulated to be approximately equal to the pressure within the first container 2, and the first container 2 is opened to allow the substrate loading chamber 18 and the first container 2 to communicate with each other. Following this, the substrate loading mechanism 19 is used to load the substrate 3 into the first container 2. To be specific, the substrate loading mechanism 19 is used to place the substrate placing member 11 having, for example, the substrate 3 placed thereon onto the substrate transporting mechanism 22, which is configured to transport substrates 3 along the transport path within the first container 2 extending from the entrance 4 to the exit 5. On completion of the loading of the substrate 3 into the first container 2, the substrate loading mechanism 19 retreats outside the first container 2, and the gate valve 6 between the substrate loading chamber 18 and the first container 2 is closed.

During the loading of the substrate 3 into the first container 2, the protective gas such as a hydrogen containing gas (for example, NH₃ gas) may be fed into the first container 2 through the Group V source gas feeding tube 30 while the gas discharge unit discharges the gases from the first container 2. In other words, while the APC valve 41 is kept opened with the opening formed in the upper container 9 included in the second container 8 being kept opened in order to discharge the gases from the first container 2 through the second container 8, the valve 34 of the Group V source gas feeding tube 30 may be opened to feed the NH₃ gas into the first container 2 through the second container 8. In this way, the transport path for substrates 3 between the entrance 4 and the second container 8 can be accommodated in the NH₃ gas atmosphere. With such a configuration, while the untreated substrate 3 travels along the transport path between the entrance 4 and the second container 8, a pre-treatment can be performed to, for example, remove the particles adhering to the surface of the substrate 3, or the particles can be prevented from adhering to the substrate 3. Here, the NH₃ gas continues to be fed into the second container 8 at least until the heating unit temperature lowering and atmospheric pressure restoring step (S100), which will be described later.

### (Preheating Step S30))

Subsequently, during the transport path between the entrance 4 and the second container 8, the untreated substrate 3, which has been loaded into the first container 2 through the entrance 4 and is to be housed within the second container 8, is preheated. To be specific, the temperature of the untreated substrate 3 is raised to a predetermined temperature during the transport path between the entrance 4 and the second container 8, which is configured to have such a length that the temperature of the untreated substrate 3 can be raised to the predetermined temperature that allows the untreated substrate 3 to be subjected to a predetermined treatment immediately after the untreated substrate 3 is housed within the second container 8.

### (Substrate Loading Step into Second Container (S40))

Once the substrate transporting mechanism 22 has transported the substrate 3 placed on the substrate placing member 11 to a position where the substrate 3 opposes the second container 8, the lift mechanism 23 lifts the substrate placing member 11, which is formed as the lower container 10, to a predetermined position to close the opening formed in the upper container 9 constituting the second container 8. In this way, the substrate 3 placed on the substrate placing member 11 is loaded into the second container 8 and housed within the second container 8.

### (Depositing Step S50))

Once the temperature of the substrate 3 housed within the second container 8 reaches a predetermined temperature, the Group III source gas starts to be fed into the second container 8 through the Group III source gas feeding tube 31 and via the source gas feeding nozzle 29 while the gases are discharged through the gas discharge tube 40. To be specific, the valve 36 provided in the Group III source gas feeding tube 31 is opened to start feeding the HCl gas from the reactant gas source 37 into the Ga tank 35, which starts the generation of the GaCl gas. The GaCl gas generated in the Ga tank 35 is fed into the second container 8 through the source gas feeding nozzle 29. Here, concurrently with the feeding of the GaCl gas into the second container 8, the Group V source gas such as NH₃ gas is fed into the second container 8 through the Group V source gas feeding tube 30 and via the source gas feeding nozzle 29. In the second container 8, the Group III source gas such as the GaCl gas and the Group V source gas such as the NH₃ gas react with each other to grow a GaN film having a predetermined thickness on the substrate 3. After a predetermined treatment duration has elapsed and the thickness of the GaN film reaches the predetermined thickness, the GaCl gas is stopped from being fed into the second container 8. To be specific, the valve 36 of the Group III source gas feeding tube 31 is closed to stop feeding the HCl gas into the Ga tank 35. Here, the NH₃ gas continues to be fed through the Group V source gas feeding tube 30 into the second container 8. Furthermore, the heater 17 continues heating the substrate 3 housed within the second container 8.

### (Purging Step (S60))

Once the depositing step (S50) has completed, the Group III source gas such as the GaCl gas is discharged from the second container 8. Here, the discharge of the GaCl gas from the second container 8 can be facilitated by keeping the valve 34 of the Group V source gas feeding tube 30 opened, continuing feeding the NH₃ gas into the second container 8 and continuing the discharge of the gases from the second container 8 by the gas discharge unit. The above-described configuration can prevent, for example, the reaction products from adhering to the mobile units such as the lift mechanism 23 included in the substrate transporting mechanism 22, which can contribute to avoid malfunctions of the substrate transporting mechanism 22.

### (Substrate Unloading Step from Second Container (S70))

Once the purging step has completed, the lift mechanism 23 included in the substrate transporting mechanism 22 lowers the lower container 10 (i.e., the substrate placing member 11) down to a predetermined position to open the opening in the upper container 9. In this way, the substrate 3 placed on the substrate placing member 11, which is formed as the lower container 10, is unloaded out of the second container 8.

### (Temperature Lowering Step (S80))

Following this, the temperature of the treated substrate 3 unloaded out of the second container 8 is lowered to a predetermined temperature during the transport path between the second container 8 and the exit 5. The transport path between the second container 8 and the exit 5 is configured to have such a length that the temperature of the treated substrate 3 can be lowered at least to a predetermined temperature that allows the treated substrate 3 to be unloaded out of the first container 2. In other words, the heat of the treated substrate 3 is dissipated along the transport path between the second container 8 and the exit 5 to lower the temperature of the treated substrate 3 to a predetermined temperature.

### (Substrate Unloading Step out of First Container (S90))

Once the temperature of the treated substrate 3 is lowered to the predetermined temperature, the gate valve 7 between the first container 2 and the substrate unloading chamber 20 is opened to allow the first container 2 and the substrate unloading chamber 20, in which the pressure has been regulated to be approximately equal to the pressure within the first container 2, to communicate with each other. Following this, the substrate unloading mechanism 21 is used to unload the substrate 3 out of the first container 2. To be specific, the substrate unloading mechanism 21 is used to unload out of the first container 2 the substrate 3, which has been transported to the exit 5 by the substrate transporting mechanism 22, while being placed on the substrate placing member 11. Once the substrate 3 has been unloaded out of the first container 2, the substrate unloading mechanism 21 retreats outside the first container 2, and the gate valve 7 between the first container 2 and the substrate unloading chamber 20 is closed to block the air from flowing into the first container 2. Stated differently, the first container 2 is closed airtightly. By performing the above-described series of steps, the substrate treating step of a single substrate 3 is completed.

(Heating Unit Temperature Lowering and Atmospheric Pressure Restoring Step (S100))After a predetermined number of substrates 3 have been treated, the power fed to the heater 17 is stopped and the temperature of the heater 17 is lowered. In addition, the aperture of the APC valve is regulated to restore the atmospheric pressure in the first container 2. Here, the substrate treating step relating to the present embodiment ends.

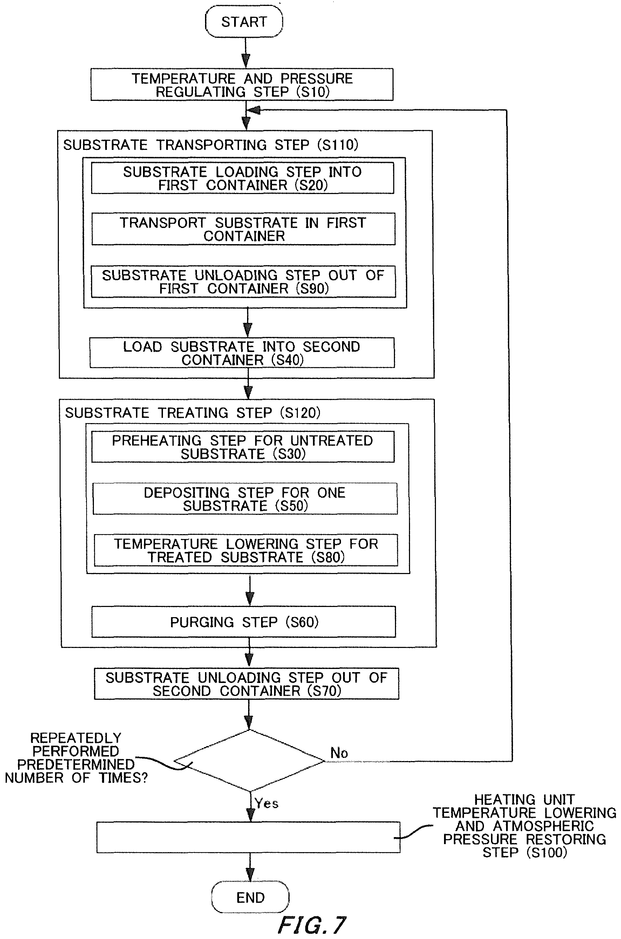

The following describes how the semiconductor manufacturing apparatus 1 is operated during the above-described substrate treating step with reference to Fig. 7. Fig. 7 is a flow chart showing how the semiconductor manufacturing apparatus 1 is operated during the above-described substrate treating step. As shown in Fig. 7, in order to perform a predetermined treatment on a substrate 3, the semiconductor manufacturing apparatus 1 first performs the above-described temperature and pressure regulating step (S10). Once the predetermined pressure is achieved in the first container 2 and the heating temperature of the heater 17 reaches the predetermined temperature, the semiconductor manufacturing apparatus 1 performs the substrate transporting step (S110). In other words, the semiconductor manufacturing apparatus 1 concurrently performs the substrate loading step into the first container 2 (S20), the substrate unloading step from the first container 2 (S90) and the transport of a plurality of substrates 3 arranged in a line respectively to downstream predetermined positions along the transport path within the first container 2. After completing the substrate transporting step (S110), the semiconductor manufacturing apparatus 1 performs the substrate treating step (S120). To be specific, the semiconductor manufacturing apparatus 1 concurrently performs the above-described preheating step (S30), the depositing step (S50) and the temperature lowering step (S80). Specifically speaking, while the depositing step (S50) is performed on one of the substrates 3 within the second container 8, the preheating step (S30) is performed on another one of the substrates 3, which has not been treated, along the transport path between the entrance 4 and the second container 8, and the temperature lowering step (S80) is performed on yet another one of the substrates 3, which has been treated, during the transport path between the second container 8 and the exit 5. On completion of the depositing step (S50) performed on one of the substrates 3 in the second container 8, the semiconductor manufacturing apparatus 1 performs the above-described purging step (S60). On completion of the purging step (S60), the semiconductor manufacturing apparatus 1 performs the above-described substrate unloading step from the second container (S70). On completion of the substrate unloading step from the second container (S70), the semiconductor manufacturing apparatus 1 performs the above-described substrate transporting step (S110) again. The substrate unloading step from the second container (S70) may be considered to be part of the substrate transporting step (S110). While performing the substrate treating step, the semiconductor manufacturing apparatus 1 repeatedly performs the above-described series of steps a predetermined number of times. After repeatedly performing the above-described series of steps a predetermined number of times, the semiconductor manufacturing apparatus 1 performs the above-described heating unit temperature lowering and atmospheric pressure restoring step (S100) to lower the temperature of the heater 17 and restore the atmospheric pressure within the first container 2. In this way, the semiconductor manufacturing apparatus 1 completes the predetermined series of steps.

As described above, the semiconductor manufacturing apparatus 1 raises the temperature of the heater 17 before performing the substrate loading step into the first container 2 (S20) for the first substrate 3 to be first treated, and lowers the temperature of the heater 17 after completing the substrate unloading step out of the second container 8 (S70) on the last substrate 3 to be treated. In other words, the temperature of the treated substrate 3 can be lowered to a predetermined temperature and then unloaded out of the first container 2 while the heating temperature of the heater 17 is kept at such a temperature that the substrate 3 housed in the second container 8 can be heated to a predetermined temperature, that is to say, without lowering the heating temperature of the heater 17. As a result, the productivity can be improved.

### (3) Effects Produced by the Present Embodiment

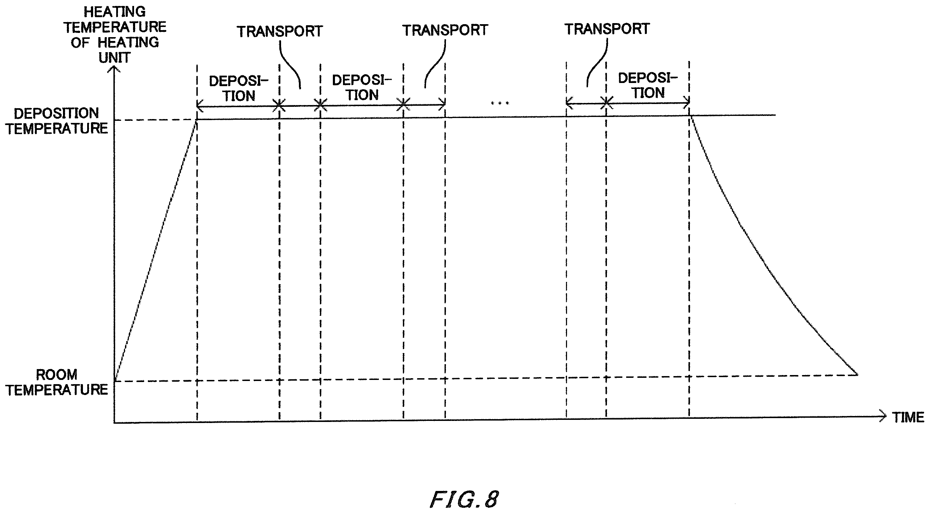

The present embodiment produces the following one or more effects.
(a) The substrate loading mechanism 19 and the substrate unloading mechanism 21, which may serve as the driving units to drive the substrate transporting mechanism 22, can be respectively configured to be detachable from the substrate transporting mechanism 22. With such a configuration, while a substrate 3 is being treated within the second container 8, the substrate loading mechanism 19 and the substrate unloading mechanism 21 can respectively retreat out of the first container 2 (i.e., to the substrate loading chamber 18 and the substrate unloading chamber 20) and the gate valves 6 and 7 can be closed. In other words, even if the substrate loading mechanism 19 and the substrate unloading mechanism 21 are not introduced into the first container 2, the substrate transporting mechanism 22 can be driven to transport the substrate 3. This can reduce the number of through holes formed in the first container 2. For example, the through holes to dispose the substrate loading mechanism 19 and the substrate unloading mechanism 21 do not need to be formed. This can improve the air tightness within the first container 2. Accordingly, impurities and the like can be prevented from being introduced into the first container 2 while a predetermined treatment is performed within the second container 8. This can prevent the impurities from being introduced into the second container 8. As a result, the semiconductor manufacturing apparatus 1 can deposit a thin film with improved quality on the substrate 3.
(b)The present embodiment can produce especially useful effects when, within the second container 8, the substrate 3 is heated to a high temperature and, at the same time, a corrosive gas is used as the source gas. In other words, the present embodiment produces especially useful effects when a seal member such as a magnetic seal and a bellows cannot be used.
(c) The substrate 3 is subjected to a predetermined treatment within the second container 8, which is disposed within the first container 2. Simply by forming a close contact between the upper container 9 and the lower container 10, which together constitute the second container 8, the second container 8 can be airtightly enclosed to which the source gas is fed through the source gas feeding nozzle 29. In other words, the second container 8 can be airtightly enclosed without using a seal member such as a magnetic seal and a bellows. Accordingly, impurities can be prevented from being introduced into the second container 8 while a predetermined treatment is performed on the substrate 3. As a result, the semiconductor manufacturing apparatus lean deposit a thin film with improved quality on the substrate 3.
(d) The transport path between the second container 8 and the exit 5 is configured to have such a length that the temperature of the treated substrate 3, which has been unloaded out of the second container 8, can be lowered at least to a predetermined temperature that allows the treated substrate 3 to be unloaded out of the first container 2. With such a configuration, the temperature of the treated substrate 3 can be lowered without lowering the heating temperature of the heater 17. In other words, the temperature of the treated substrate 3 can be lowered while the heating temperature of the heater 17 is kept at a predetermined temperature (for example, the temperature high enough to heat the substrate 3 up to a treatment temperature). With such a configuration, after the completion of the treatment on one of the substrates 3 within the second container 8 and before the start of the treatment on the next one of the substrates 3, the heating temperature of the heater 17 does not need to be raised and lowered. Accordingly, the time period between the completion of the treatment on one of the substrates 3 within the second container 8 and the start of the treatment on the next one of the substrate 3 can be shortened. This can improve the productivity of the manufacturing process of substrates 3 having a thin film formed thereon.
   For example, the heater 17 can operate in accordance with the operational sequence shown in Fig. 8. Here, the transport time period shown in Fig. 8 denotes the period of time between the completion of the treatment on a substrate 3 within the second container 8 and before the start of the treatment on the next substrate 3 within the second container 8. As shown in Fig, 8, the heating temperature of the heater 17 is raised only at the initial stage and lowered only at the last stage in accordance with the present embodiment. In other words, the heating temperature of the heater 17 is maintained at such a level that the heater 17 is capable of heating the substrate 3 to a predetermined temperature (for example, the deposition temperature) even while the substrate 3 is loaded and unloaded into and out of the second container 8.
(e) The temperature of the treated substrate 3 is lowered to such a temperature that the treated substrate 3 can be unloaded out of the first container 2 during the transport path between the second container 8 and the exit 5. In this manner, when the substrate unloading mechanism 21 unloads the treated substrate 3 out of the first container 2, the substrate unloading mechanism 21 can be prevented from being heated and damaged by the heat of the substrate 3. Accordingly, it is possible to prevent the drop in the transport accuracy of the substrate unloading mechanism 21.
(f) By providing a long transport path between the second container 8 and the exit 5, the temperature of the atmosphere along the transport path between the second container 8 within the first container 2 and the exit 5 gradually drops toward the exit 5. Stated differently, the atmosphere along the transport path between the second container 8 within the first container 2 and the exit 5 has a temperature distribution in which the highest temperature is observed near the second container 8 and the lowest temperature is observed near the exit 5. As a result, the temperature of the substrate 3 can be lowered in such a manner that the temperature of the substrate 3, which is transported along the transport path between the second container 8 and the exit 5 gradually drops toward the exit 5. Stated differently, the above-described configuration can prevent the substrate 3 from being cooled down rapidly. This can prevent the substrate 3 from being cracked (or damaged) while the temperature of the substrate 3 is lowered.
(g) Since a predetermined treatment is performed on the substrate 3 within the second container 8 positioned within the first container 2, it is not necessary to provide a reactant gas atmosphere such as a GaCl gas atmosphere and the like in the first container 2 to perform the predetermined treatment on the substrate 3. With such a configuration, the step of performing a predetermined treatment on a substrate 3 within the second container 8 can be conducted concurrently with the step of lowering the temperature of a treated substrate 3 along the transport path between the second container 8 within the first container 2 and the exit 5. As a result, the productivity can be further improved.
(h) By heating the substrate 3 to perform a predetermined treatment on the substrate 3 within the second container 8, the reaction products generated within the second container 8 can be prevented from adhering to the substrate transporting mechanism 22. With such a configuration, the substrate transporting mechanism 22 can be prevented from malfunctioning.
(i) The transport path between the entrance 4 and the second container 8 is configured to have such a length that the temperature of the untreated substrate 3 to be loaded into the second container 8 can be raised to a predetermined temperature. With such a configuration, after the substrate 3 is housed in the second container 8, the temperature of the substrate 3 can reach a predetermined treatment temperature within a shortened period of time. Accordingly, the period of time between the completion of the treatment of one substrate 3 within the second container 8 and the start of the treatment of the next substrate 3 can be shortened. As a result, the productivity can be further improved.
(j) By providing a long transport path between the entrance 4 and the second container 8, a long distance can be provided between the substrate loading chamber 18 and the second container 8. Accordingly, a long distance can be provided between the substrate loading chamber 18 and the heater 17. By providing a long transport path between the second container 8 and the exit 5, a long distance can be provided between the substrate unloading chamber 20 and the second container 8. Accordingly, a long distance can be provided between the substrate unloading chamber 20 and the heater 17. With such a configuration, the substrate loading mechanism 19 in the substrate loading chamber 18 and the substrate unloading mechanism 21 in the substrate unloading chamber 20 can be prevented from being heated and resultantly damaged by the heat generated by the heater 17. Accordingly, it is possible to further prevent the drop in the transport accuracy of the substrate loading mechanism 19 and the substrate unloading mechanism 21.
(k) The transport path between the second container 8 within the first container 2 and the exit 5 is under a protective gas atmosphere. This can prevent, for example, the modification of the thin film deposited on the surface of the treated substrate 3 and the adhesion of impurities onto the deposited thin film. As a result, it is possible to further prevent the drop in the quality of the thin film deposited on the surface of the substrate 3.
(l) By providing a protective gas atmosphere along the transport path within the first container 2 between the entrance 4 and the second container 8, the surface of the untreated substrate 3 can be prevented from being nitridized along the transport path within the first container 2 between the entrance 4 and the second container 8, and the particles can be prevented from adhering to the surface of the substrate 3. In addition, a pre-treatment can be also performed to remove the particles that have adhered to the surface of the substrate 3. As a result, it is possible to further prevent the drop in the quality of the thin film deposited on the surface of the substrate 3.
(m) Since the substrate transporting mechanism 22 includes at least one of a push-pull mechanism, a walking beam mechanism and a feeding screw mechanism, the substrate transporting mechanism 22 can achieve a simplified manner of transporting the substrate 3. To be specific, the loading and unloading of the substrate 3 into and out of the first container 2 and the transport of the substrate 3 within the first container 2 can be simplified. As a result, it is possible to further prevent the drop in the transport accuracy of the substrate 3 even if a long transport path is provided for the substrate 3 within the first container 2.
(n) While a predetermined treatment is performed within the second container 8, for example, the GaCl gas and the like may leak out of the second container 8. By providing the barrier plate 43 within the first container 2, the leaking GaCl gas can be prevented from flowing into the transport path within the first container 2. As a result, the leaking GaCl gas can be prevented from coming into contact with the treated substrate 3, which is positioned along the transport path, and from modifying the thin film deposited on the substrate 3. This can prevent the drop in the quality of the thin film on the substrate 3. In addition, the thin films deposited on the individual substrates 3 can avoid having different quality levels.

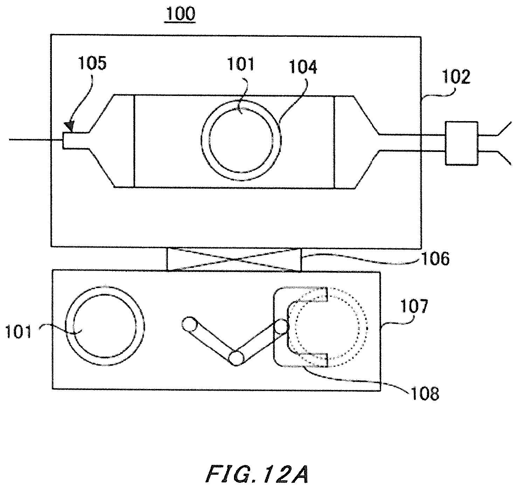

The following describes a conventional semiconductor manufacturing apparatus 100 for reference. Figs. 12A to 12D schematically show the conventional single-wafer semiconductor manufacturing apparatus 100. As shown in Figs. 12A to 12D, the semiconductor manufacturing apparatus 100 includes a treatment container 102 configured to house therein a substrate 101 and to perform a predetermined treatment on the substrate 101 and a substrate placing unit 104 provided in the treatment container 102 and configured to have the substrate 101 placed thereon. In the semiconductor manufacturing apparatus 100, a source gas is fed into the treatment container 102 from a source gas feeding unit 105 to treat the substrate 101. The substrate placing unit 104 has a shaft to lift and lower, and rotate the substrate placing unit 104. The shaft of the substrate placing unit 104 penetrates through a through hole provided in the bottom plate of the treatment container 102. Therefore, in order to keep the treatment container 102 airtight, to which the source gas is fed, a seal member such as a magnetic seal and a bellows needs to be provided between the shaft and the through hole.

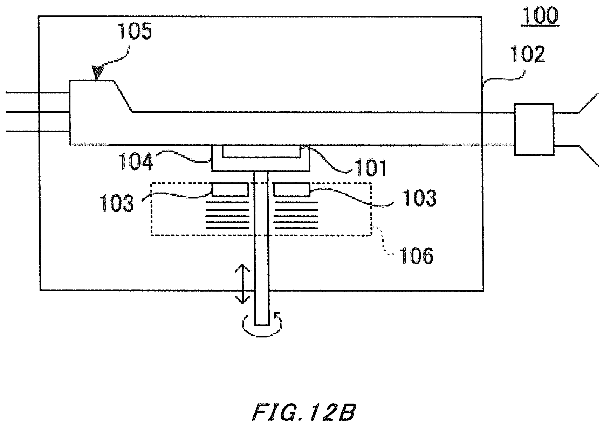

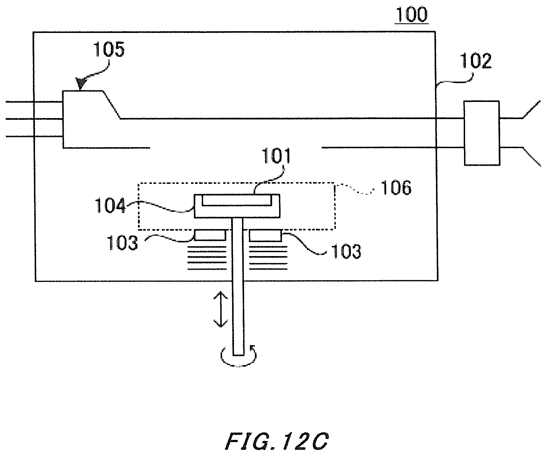

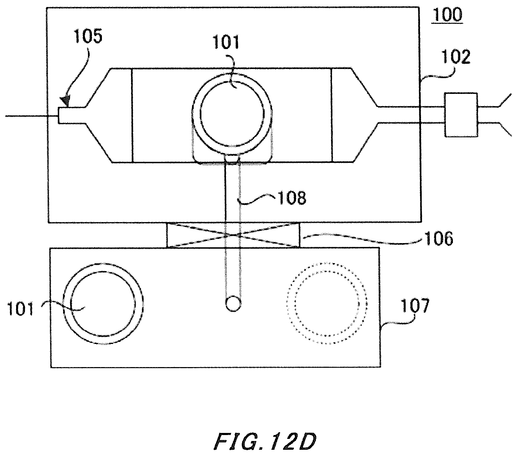

The semiconductor manufacturing apparatus 100 performs the steps of:
while the temperature in the treatment container 102 is maintained approximately at, for example, room temperature, opening a gate valve 106 serving as a sluice valve to allow a substrate standby chamber 107 to communicate with the treatment container 102 and loading the substrate 101 into the treatment container 102 by the substrate loading and unloading mechanism 108 to place the substrate 101 on the substrate placing unit 104 (for example, Fig. 12A);
after the substrate loading and unloading mechanism 108 retreats into the substrate standby chamber 107, closing the gate valve 106 to keep the treatment container 102 airtight;
lifting the substrate placing unit 104 to position the substrate 101 at a predetermined treatment position within the treatment container 102 (for example, Fig. 12B);
   heating the substrate 101 placed on the substrate placing unit 104 using a heating unit 103 to a predetermined temperature and subsequently feeding the source gas from the source gas feeding unit 105 to the substrate 101 to perform a predetermined treatment (for example, deposition on the substrate 101;
on completion of the predetermined treatment, lowering the substrate placing unit 104 to lower the substrate 101 down to a predetermined position within the treatment container 102 (for example, Fig. 12C);
cooling the substrate 101 down to a temperature (for example, approximately room temperature) at which the substrate 101 is allowed to be unloaded out of the treatment container 102 by the substrate loading and unloading mechanism 108; and
opening the gate valve 106 to unload the substrate 101 out of the treatment container 102 to the substrate standby chamber 107 by the substrate loading and unloading mechanism 108 (Fig. 12D).

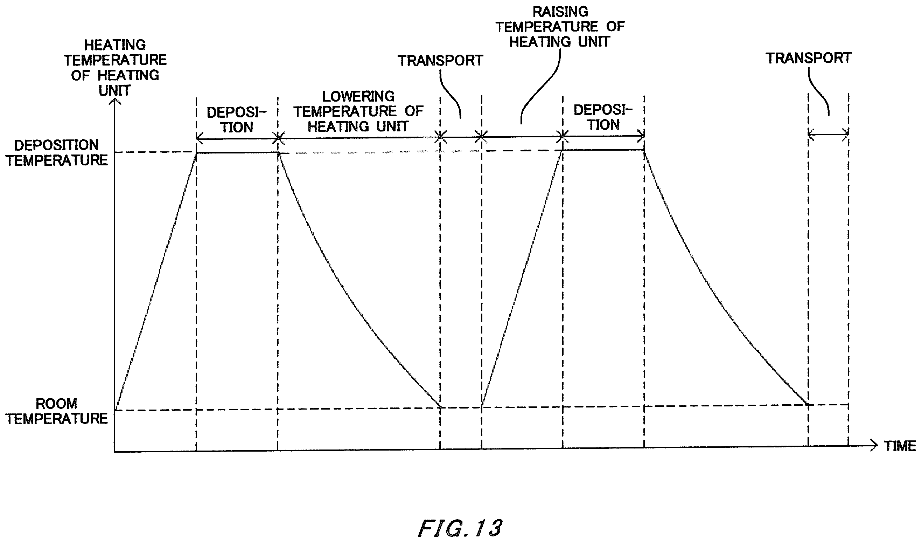

Fig. 13 shows the operational sequence of the heating unit 103 included in the semiconductor manufacturing apparatus 100. As shown in Fig. 13, in the semiconductor manufacturing apparatus 100, the heating unit 103 heats the substrate 101 within the treatment container 102 to perform a predetermined treatment, and the heating temperature of the heating unit 103 is subsequently lowered in order to lower the temperature of the substrate 101 and the temperature within the treatment container 102 to a predetermined temperature. For example, the power supply to the heating unit 103 is stopped. Subsequently, the heating temperature of the heating unit 103 is raised again when the next substrate 101 is subjected to a predetermined treatment in the treatment container 102. For such a reason, the semiconductor manufacturing apparatus 100 spends a long time to raise and lower the temperature of the heating unit 103. There may be cases where several dozen minutes to several hours may be required between the completion of the treatment of one substrate 101 and the start of the treatment of the next substrate 101. This may compromise the productivity.

If the substrate 101 is loaded and unloaded into and out of the treatment container 102 by the substrate loading and unloading mechanism 108 while the heating temperature of the heating unit 103 is maintained and a high temperature is thus maintained within the treatment container 102, the thin film deposited on the substrate 101 may be modified and the quality of the thin film may resultantly drop.

When the substrate 101 is loaded and unloaded into and out of the treatment container 102 with the high temperature being maintained within the treatment container 102, it may be done to continue feeding the source gas into the treatment container 102 from the source gas feeding unit 105 in order to prevent the modification of the thin film deposited on the substrate 101. For example, when the thin film deposited on the substrate 101 is a GaN film, it is necessary to continue feeding the GaCl gas and the NH₃ gas into the treatment container 102 from the source gas feeding unit 105 in order to prevent the modification of the GaN film. Since the GaCl gas and the NH₃ gas are corrosive gases, the adhesion of these gases onto the substrate loading and unloading mechanism 108 may cause corrosion of the substrate loading and unloading mechanism 108.

In addition, when the substrate 101 is loaded and unloaded into and out of the treatment container 102 by the substrate loading and unloading mechanism 108 with the high temperature being maintained within the treatment container 102, the substrate loading and unloading mechanism 108 may be heated by the heat and damaged.

According to the present embodiment, in contrast to the above, the second container 8 is disposed within the first container 2 and the substrate 3 is treated within the second container 8, and the substrate loading mechanism 19 and the substrate unloading mechanism 21, which are configured as the driving units to drive the substrate transporting mechanism 22, are respectively detachable from the substrate transporting mechanism 22. Accordingly, the second container 8, into which the source gas is to be fed, can be kept airtight without using a seal member. In addition, the transport path between the second container 8 and the exit 5 is configured to such a length that the temperature of the treated substrate 3 unloaded out of the second container 8 can be lowered at least to a predetermined temperature at which the treated substrate 3 is allowed to be unloaded out of the first container 2. As a result, even if the substrate transporting mechanism 22 is operated by the substrate loading mechanism 19 and the substrate unloading mechanism 21 while the heating temperature of the heater 17 is kept at a predetermined temperature (for example, the treatment temperature), the substrate loading mechanism 19 and the substrate unloading mechanism 21 can be prevented from being damaged.

### (Other Embodiments)

One embodiment of the present invention has been specifically described. The present invention, however, is not limited to the above-described embodiment, which can be modified as appropriate within the scope of the present invention.

According to the above-described embodiment, the source gas starts to be fed while the gases are discharged through the gas discharge tube 40 once the temperature of the substrate 3 housed within the second container 8 reaches a predetermined temperature. The present invention, however, is not limited to such. In other words, the discharging of the gases through the gas discharge tube 40 starts after the temperature of the substrate 3 housed within the second container 8 reaches a predetermined temperature. The present invention, however, is not limited to such. For example, the discharging of the gases through the gas discharge tube 40 may start while the substrate 3 housed within the second container 8 is still being heated to reach a predetermined temperature.

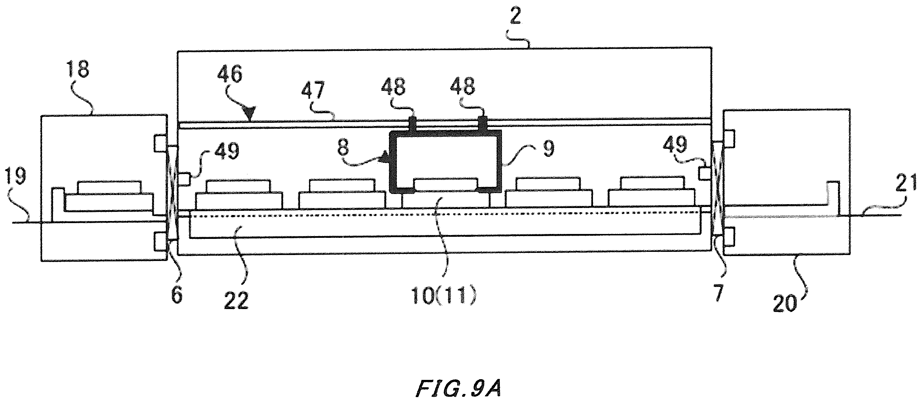

According to the above-described embodiment, the substrate 3 is loaded and unloaded into and out of the second container 8 by lifting and lowering the substrate placing member 11, which is configured as the lower container 10, by the lift mechanism 23. The present invention, however, is not limited to such. For example, as shown in Figs. 9A to 9C, by lifting and lowering the upper container 9 included in the second container 8, the substrate 3 may be loaded and unloaded into and out of the second container 8. This configuration can also produce at least the above-described effects (a) to (c).

Specifically speaking, an upper container lift mechanism 46 may be provided in the first container 2 to lift and lower the upper container 9. The upper container lift mechanism 46 may be configured to lower the upper container 9 until the lower end of the upper container 9 comes into contact with the lower container 10 (for example, the substrate placing member 11) to close the opening formed in the upper container 9, and to lift the upper container 9 to open the opening formed in the upper container 9. The upper container lift mechanism 46 may be configured to lift and lower the upper container 9 in coordination with the opening and closing of the gate valves 6 and 7.

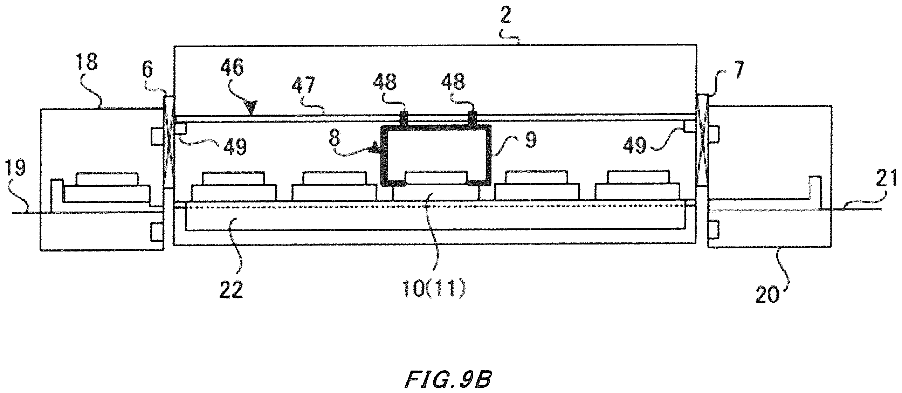

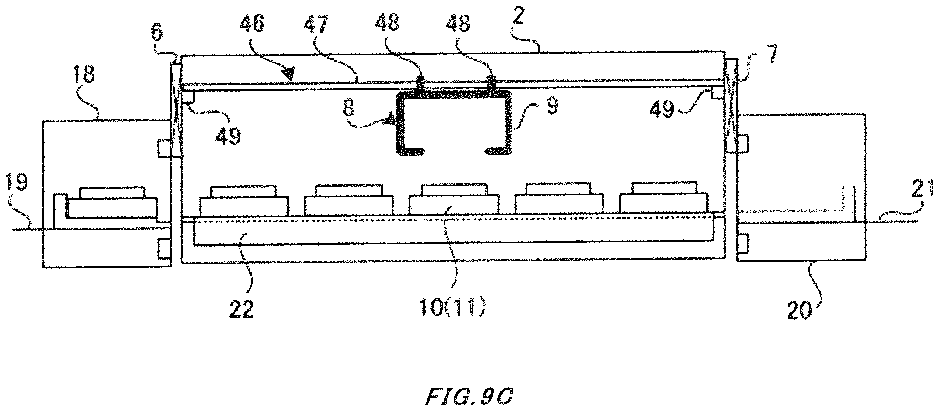

For example, the upper container lift mechanism 46 may be constituted by a rod member 47, an attaching unit 48 that is provided on the upper container 9 and used to attach the rod member 47 thereto, and engaging units 49 that are provided respectively on the gate valves 6 and 7 and engage with the respective ends of the rod member 47. The rod member 47 may be configured to be capable of bridging the engaging units 49 respectively provided at the gate valves 6 and 7. The rod member 47 may be made of quartz and the like. The attaching unit 48 may be disposed on the outer wall of the top plate of the upper container 9, for example. For example, a through hole may be formed in the attaching unit 48. The rod member 47 is attached to the upper container 9 by allowing the rod member 47 to penetrate through the through hole. With such a configuration, as the gate valves 6 and 7 are lifted, the respective ends of the rod member 47 engage with the engaging unit 49 (Fig. 9B). As the gate valves 6 and 7 are further lifted, the rod member 47 and the upper container 9 rise, and the opening formed at the lower end of the upper container 9 can be resultantly opened (Fig. 9C). The upper container 9 is lowered in the opposite fashion to the above-described fashion in which the upper container 9 is lifted. In other words, when the gate valves 6 and 7 are lowered, the rod member 47 and the upper container 9 are lowered to close the opening formed at the lower end of the upper container 9.

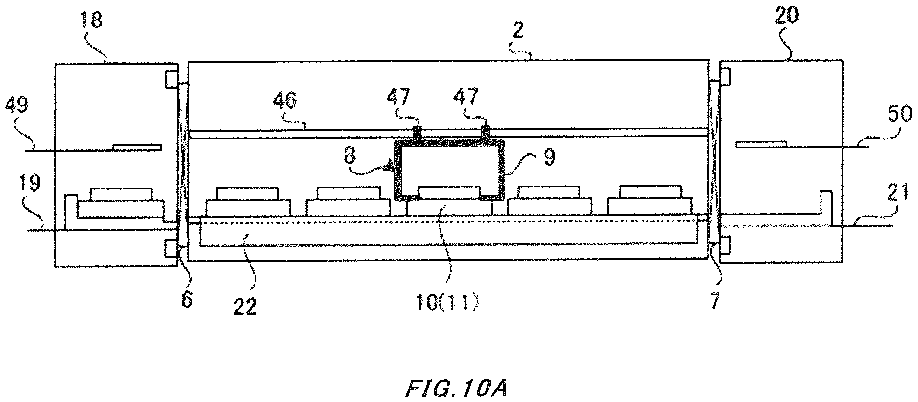

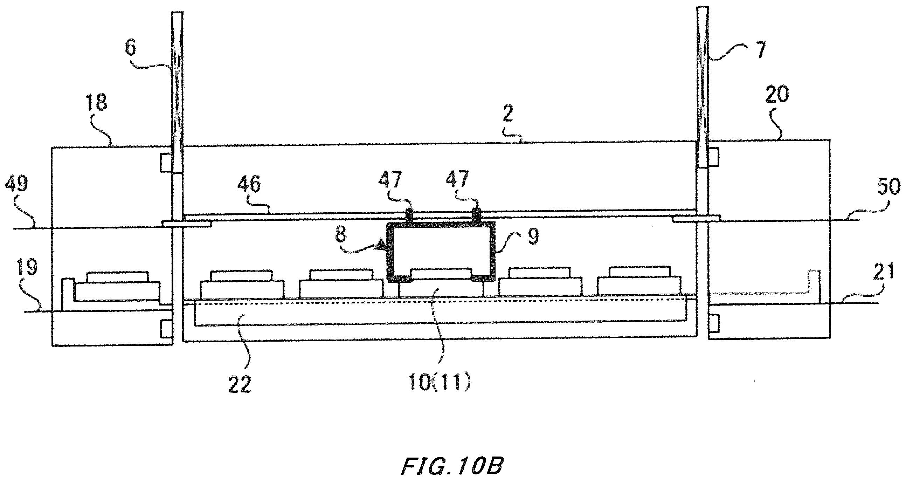

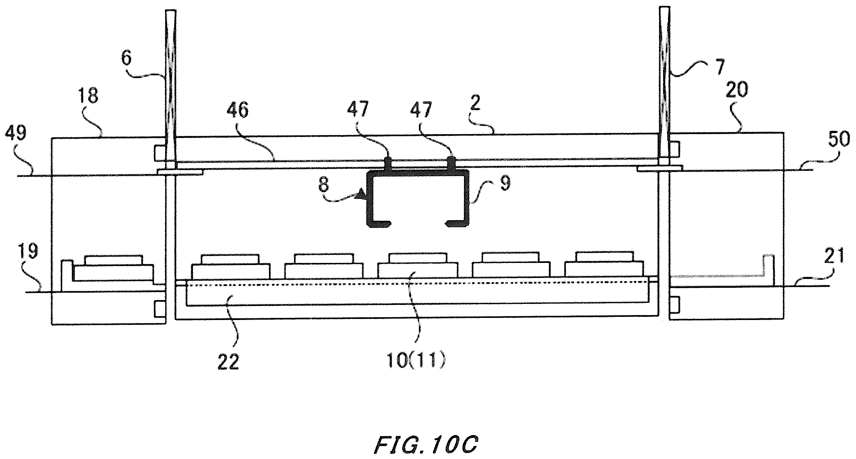

Alternatively, as shown in Figs. 10A to 10C, for example, the upper container lift mechanism 46 may include a rod member 47, a lift mechanism 49 provided in the substrate loading chamber 18, and a lift mechanism 50 provided in the substrate unloading chamber 20. To the lift mechanisms 49 and 50 respectively, the control unit 45 is connected. The control unit 45 is configured to control the power fed to the lift mechanisms 49 and 50 in such a manner that the lift mechanisms 49 and 50 both position the rod member 47 at a predetermined height at a predetermined timing. The upper container 9 is lifted and lowered as shown in Figs. 10A to 10C. To start with, the gate valves 6 and 7 are lifted to allow the substrate loading chamber 18 and the substrate unloading chamber 20 to communicate with each other. Subsequently, the lift mechanism 49 provided in the substrate loading chamber 18 and the lift mechanism 50 provided in the substrate unloading chamber 20 enter the first container 2 to respectively support the respective ends of the rod member 46 (Fig. 10B). As the lift mechanisms 49 and 50 are lifted, the rod member 46 rises and the upper container 9 accordingly rises (Fig. 10C). The upper container 9 is lowered in the opposite fashion to the above-described fashion in which the upper container 9 is lifted. This configuration can also produce at least the above-described effects (a) to (c).

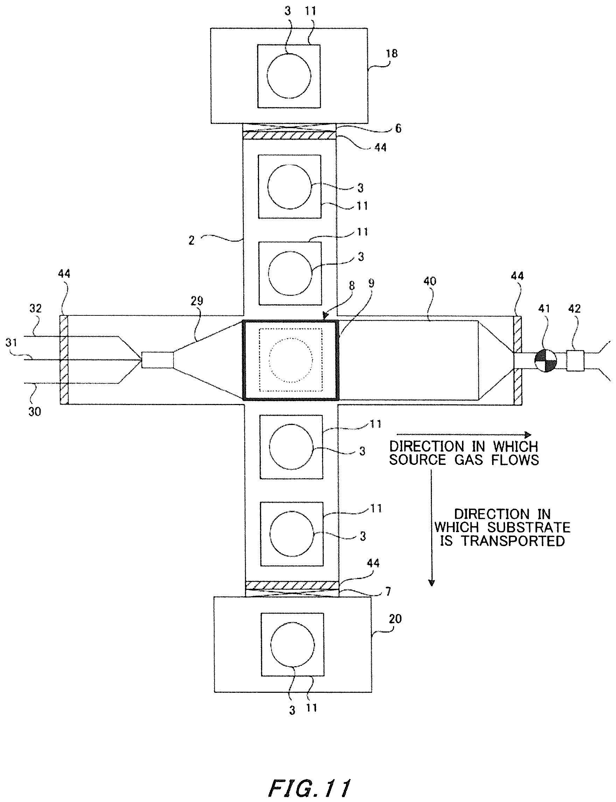

According to the above-described embodiment, the direction in which the substrate 3 is transported within the first container 2 is the same as the direction in which the source gas flows within the second container 8. The present invention, however, is not limited to such. For example, as shown in Fig. 11, the transport path may be positioned within the first container 2 in such a manner that the direction in which the substrate 3 is transported within the first container 2 horizontally intersects at right angles with the direction in which the source gas flows within the second container 8. As an alternative example, the transport path may be positioned within the first container 2 in such a manner that the direction in which the substrate 3 is transported within the first container 2 vertically intersects at right angles with the direction in which the source gas flows within the second container 8. Stated differently, for example in Fig. 1, the transport path may be provided within the first container 2 in such a manner that the substrate 3 is transported within the first container 2 from the ceiling toward the floor. With these configurations, the same effects as the above-described embodiments can be produced.

According to the above-described embodiment, in the second container 8, the substrate 3 is subjected to a treatment that heats the substrate 3 in order to deposit a GaN film. The present invention, however, is not limited to such. As another example, within the second container 8, the substrate 3 may be subjected to a cleaning treatment to remove the GaN film and the like adhering to the substrate placing member 11, which is formed as the lower container 10. To be specific, the substrate placing member 11 without the substrate 3 being placed thereon is loaded into the first container 2 and lifted by, for example, the lift mechanism 23 to close the opening in the upper container 9. Subsequently, while the gases are being discharged through the gas discharge tube 40, the cleaning gas starts to be fed into the second container 8 from the cleaning gas feeding tube 32 via the source gas feeding nozzle 29. To be specific, while the APC valve 41 is opened with the opening formed in the upper container 9 included in the second container 8 being kept open in order to discharge gases from the first container 2 through the second container 8, the valve 39 provided in the cleaning gas feeding tube 32 is opened to start feeding the cleaning gas from the cleaning gas source 38. Once a predetermined period of time has elapsed and the cleaning of the substrate placing member 11 is completed, the valve 39 is closed to stop feeding the cleaning gas into the second container 8.

According to the above-described embodiment, the predetermined treatment involving heating the substrate 3 is a treatment to deposit a gallium nitride (GaN) film. The present invention, however, is not limited to such. The present invention can be similarly applied to other treatments such as treatments to deposit various films on the substrate 3.

While the embodiments of the present invention have been described, the technical scope of the invention is not limited to the above described embodiments. It is apparent to persons skilled in the art that various alterations and improvements can be added to the above-described embodiments. It is also apparent from the scope of the claims that the embodiments added with such alterations or improvements can be included in the technical scope of the invention, which is defined by the appended claims.

The operations, procedures, steps, and stages of each process performed by an apparatus, system, program, and method shown in the claims, embodiments, or diagrams can be performed in any order as long as the order is not indicated by "prior to," "before," or the like and as long as the output from a previous process is not used in a later process. Even if the process flow is described using phrases such as "first" or "next" in the claims, embodiments, or diagrams, it does not necessarily mean that the process must be performed in this order.

### DESCRIPTION OF REFERENCE NUMERALS

- 1: semiconductor manufacturing apparatus
- 2: first container
- 3: substrate
- 4: entrance
- 5: exit
- 8: second container
- 17: heater (heating unit)
- 22: substrate transporting mechanism

## Claims

1. A semiconductor manufacturing apparatus comprising:
a first container (2) provided with an entrance (4) and an exit (5) for a plurality of substrates (3);
a substrate loading chamber (18) connected to the entrance (4), the substrate loading chamber (18) configured to be capable of loading thereinto from outside the substrates (3) that are to be loaded into the first container (2) and of being blocked from the first container (2) and the atmosphere;
a substrate unloading chamber (20) connected to the exit (5), the substrate unloading chamber (20) configured to be capable of unloading to outside the substrates (3) that have been unloaded out of the first container (2) and of being blocked from the first container (2) and the atmosphere;
a second container (8) disposed within the first container (2), the second container (8) configured to allow a predetermined treatment to be performed therein by heating the substrates (3);
a heating unit (17) configured to heat the substrates (3) housed within the second container (8); and
a substrate transporting mechanism (22) configured to transport the substrates (3) arranged in a line along a transport path extending within the first container (2) from the entrance (4) to the exit (5) and to load and unload the substrates (3) into and out of the second container (8) in order, **characterized by**
driving units (19, 21) configured to drive the substrate transporting mechanism (22) are configured to be detachable from the substrate transporting mechanism (22) and respectively disposed within the substrate loading chamber (18) and the substrate unloading chamber (20).

2. The semiconductor manufacturing apparatus as set forth in Claim 1, wherein
the transport path between the second container and the exit is configured to have such a length that a temperature of the substrates that have been treated and unloaded out of the second container is lowered at least to a predetermined temperature at which the treated substrates are allowed to be unloaded out of the first container.

3. The semiconductor manufacturing apparatus as set forth in one of Claims 1 and 2, wherein
the heating unit maintains a predetermined heating temperature even while the substrates are loaded and unloaded into and out of the second container.

4. The semiconductor manufacturing apparatus as set forth in one of Claims 1 to 3, wherein
the transport path between the entrance and the second container is configured to have such a length that a temperature of the substrates to be loaded into the second container is raised to a predetermined temperature.

5. The semiconductor manufacturing apparatus as set forth in one of Claims 1 to 4, wherein
the second container is provided with a source gas feeding unit configured to feed a source gas to the substrates housed within the second container, and
deposition is performed by heating the substrates within the second container.

6. The semiconductor manufacturing apparatus as set forth in one of Claims 1 to 5, wherein
the transport path between the second container and the exit is under a protective gas atmosphere to protect a surface of the substrates that have been treated.

7. The semiconductor manufacturing apparatus as set forth in one of Claims 1 to 6, wherein
the transport path between the entrance and the second container is under a protective gas atmosphere to protect a surface of the substrates that have not been treated.

8. The semiconductor manufacturing apparatus as set forth in one of Claims 1 to 7, wherein
the substrate transporting mechanism includes one of a push-pull mechanism, a walking beam mechanism and a feeding screw drive mechanism.

## Patentansprüche

1. Halbleiterherstellungsvorrichtung aufweisend:
einen ersten Behälter (2), der mit einem Eingang (4) und einem Ausgang (5) für mehrere Substrate (3) versehen ist;
eine mit dem Eingang (4) verbundene Substratladekammer (18), wobei die Substratladekammer (18) konfiguriert ist, fähig zu sein, von außen die Substrate (3), die in den ersten Behälter (2) zu laden sind, zu laden und von dem ersten Behälter (2) und der Atmosphäre abgeriegelt zu werden;
eine mit dem Ausgang (5) verbundene Substratentladekammer (20), wobei die Substratentladekammer (20) konfiguriert ist, fähig zu sein, die Substrate (3), die aus dem ersten Behälter (2) entladen worden sind, nach außen zu entladen und von dem ersten Behälter (2) und der Atmosphäre abgeriegelt zu werden;
einen in dem ersten Behälter (2) angeordneten zweiten Behälter (8), wobei der zweite Behälter (8) konfiguriert ist, darin eine Durchführung einer vorgegebenen Behandlung durch Erhitzen der Substrate (3) zu erlauben;
eine Heizeinheit (17), die konfiguriert ist, die in dem zweiten Behälter (8) aufgenommenen Substrate (3) zu erhitzen; und
einen Substrattransportmechanismus (22), der konfiguriert ist, die in einer Linie angeordneten Substrate (3) entlang eines Transportpfads, der sich in dem ersten Behälter (2) von dem Eingang (4) zu dem Ausgang (5) erstreckt, zu transportieren und die Substrate in den und aus dem Behälter (8) der Reihe nach zu laden und zu entladen,
**gekennzeichnet durch**
Antriebseinheiten (9, 21), die konfiguriert sind, den Substrattransportmechanismus (22) anzutreiben, sind konfiguriert, von dem Substrattransportmechanismus (22) abnehmbar zu sein, und jeweils in der Substratladekammer (18) und der Substratentladekammer (20) angeordnet sind.

2. Halbleiterherstellungsvorrichtung nach Anspruch 1, wobei
der Transportpfad zwischen dem zweiten Behälter und dem Ausgang konfiguriert ist, eine solche Länge zu haben, dass eine Temperatur der Substrate, die behandelt worden sind und aus dem zweiten Behälter entladen worden sind, mindestens auf eine vorgegebene Temperatur gesunken ist, bei der ein Entladen der behandelten Substrate aus dem ersten Behälter erlaubt ist.

3. Halbleiterherstellungsvorrichtung nach Anspruch 1 oder 2, wobei
die Heizeinheit eine vorgegebene Heiztemperatur gleich hält, während die Substrate in den und aus dem zweiten Behälter geladen und entladen werden.

4. Halbleiterherstellungsvorrichtung nach einem der Ansprüche 1 bis 3, wobei
der Transportpfad zwischen dem Eingang und dem zweiten Behälter konfiguriert ist, eine solche Länge zu haben, dass eine Temperatur der in den zweiten Behälter zu ladenden Substrate auf eine vorgegebene Temperatur gestiegen ist.

5. Halbleiterherstellungsvorrichtung nach einem der Ansprüche 1 bis 4, wobei
der zweite Behälter mit einer Quellengaszuführungseinheit versehen ist, um den in dem zweiten Behälter aufgenommenen Substraten ein Quellengas zuzuführen, und
Abscheidung durchgeführt wird durch Erhitzen der Substrate in dem zweiten Behälter.

6. Halbleiterherstellungsvorrichtung nach einem der Ansprüche 1 bis 5, wobei
der Transportpfad zwischen dem zweiten Behälter und dem Ausgang unter einer Schutzgasatmosphäre ist, um eine Oberfläche der Substrate, die behandelt worden sind, zu schützen.

7. Halbleiterherstellungsvorrichtung nach einem der Ansprüche 1 bis 6, wobei
der Transportpfad zwischen dem Eingang und dem zweiten Behälter unter einer Schutzgasatmosphäre ist, um eine Oberfläche der Substrate, die nicht behandelt worden sind, zu schützen.

8. Halbleiterherstellungsvorrichtung nach einem der Ansprüche 1 bis 7, wobei
der Substrattransportmechanismus einen Schieben-Ziehen-Mechanismus und/oder einen sich bewegenden Trägermechanismus und/oder einen Schneckenantrieb-Zuführungsmechanismus aufweist.

## Revendications

1. Appareil de fabrication de semi-conducteur comprenant :
un premier récipient (2) doté d'une entrée (4) et d'une sortie (5) pour une pluralité de substrats (3) ;
une chambre de chargement de substrat (18) raccordée à l'entrée (4), la chambre de chargement de substrat (18) étant configurée pour pouvoir charger à l'intérieur de celle-ci depuis l'extérieur les substrats (3) qui doivent être chargés dans le premier récipient (2) et être isolée du premier récipient (2) et de l'atmosphère ;
une chambre de déchargement de substrat (20) raccordée à la sortie (5), la chambre de déchargement de substrat (20) étant configurée pour pouvoir décharger à l'extérieur les substrats (3) qui ont été déchargés hors du premier récipient (2) et pour être isolée du premier récipient (2) et de l'atmosphère ;
un second récipient (8) disposé dans le premier récipient (2), le second récipient (8) étant configuré pour permettre la réalisation d'un traitement prédéterminé à l'intérieur de celui-ci en chauffant les substrats (3) ;
une unité de chauffage (17) configurée pour chauffer les substrats (3) abrités dans le second récipient (8) ; et
un mécanisme de transport de substrat (22) configuré pour transporter les substrats (3) agencés dans une ligne le long d'un chemin de transport s'étendant dans le premier récipient (2) de l'entrée (4) à la sortie (5) et pour charger et décharger les substrats (3) dans et hors du second récipient (8) dans l'ordre, **caractérisé en ce que**
des unités de commande (19, 21) configurées pour commander le mécanisme de transport de substrat (22) sont configurées pour pouvoir se détacher du mécanisme de transport de substrat (22) et respectivement disposées dans la chambre de chargement de substrat (18) et la chambre de déchargement de substrat (20).

2. Appareil de fabrication de semi-conducteur selon la revendication 1, dans lequel
le chemin de transport entre le second récipient et la sortie est configuré pour présenter une longueur telle qu'une température des substrats qui ont été traités et déchargés du second récipient est réduite au moins à une température prédéterminée à laquelle les substrats traités sont autorisés à être déchargés du premier récipient.

3. Appareil de fabrication de semi-conducteur selon l'une des revendications 1 et 2, dans lequel
l'unité de chauffage maintient une température de chauffage prédéterminée même pendant que les substrats sont chargés et déchargés dans et hors du second récipient.

4. Appareil de fabrication de semi-conducteur selon l'une des revendications 1 à 3, dans lequel
le chemin de transport entre l'entrée et le second récipient est configuré pour présenter une longueur telle qu'une température des substrats à charger dans le second réservoir est augmentée jusqu'à une température prédéterminée.

5. Appareil de fabrication de semi-conducteur selon l'une des revendications 1 à 4, dans lequel
le second récipient est doté d'une unité d'alimentation de gaz source configurée pour alimenter un gaz source aux substrats abrités dans le second récipient ; et
le dépôt est réalisé en chauffant les substrats dans le second récipient.

6. Appareil de fabrication de semi-conducteur selon l'une des revendications 1 à 5, dans lequel
le chemin de transport entre le second récipient et la sortie est sous une atmosphère de gaz protecteur, afin de protéger une surface des substrats qui ont été traités.

7. Appareil de fabrication de semi-conducteur selon l'une des revendications 1 à 6, dans lequel
le chemin de transport entre l'entrée et le second récipient est sous une atmosphère de gaz protecteur, afin de protéger une surface des substrats qui n'ont pas été traités.

8. Appareil de fabrication de semi-conducteur selon l'une des revendications 1 à 7, dans lequel
le mécanisme de transport de substrat inclut un parmi un mécanisme de pression/traction, un mécanisme de longeron mobile et un mécanisme de commande à vis d'alimentation.
